# EUROPEAN PATENT APPLICATION

(11) **EP 4 770 373 A2**
(43) Date of publication of application: **01.07.2026**
(21) Application number: 25227477.4
(22) Date of filing: 29.12.2025
(51) Int. Cl.: H10K 59/124, H10K 59/35, H10K 59/38, H10K 59/80

(54) **DISPLAY DEVICE**

(30) Priority: 30.12.2024 KR 20240201376
(71) Applicant: LG Display Co., Ltd., Seoul, 07336 (KR)
(72) Inventor: SEOK, JaeMin, 10845 Paju-si (KR); PARK, ChoonHo, 10845 Paju-si (KR)
(74) Representative: Ter Meer Steinmeister & Partner

(57) **Abstract**

Discussed is a display device including a planarization layer disposed on a substrate and a plurality of light-emitting elements which is disposed on the planarization layer and includes an anode electrode, an organic layer, and a cathode electrode, the plurality of sub-pixels includes a first sub-pixel and a second sub-pixel spaced apart from the first sub-pixel, the first sub-pixel includes a first light-emitting area emitting light of a first color, the second sub-pixel includes a second light-emitting area emitting light-emitting light of a first color, and a height of the planarization layer in the first light-emitting area is different from a height of the planarization layer in the second light-emitting area, thereby reducing reflectance of external light.

## Description

This application claims priority to Korean Patent Application No. 10-2024-0201376, filed on December 30, 2024 in the Korean Intellectual Property Office.

### BACKGROUND

### Field

The present disclosure relates to a display device, and more particularly, to a display device capable of reducing reflectance of external light.

### Discussion of the Related Art

In general, an organic light-emitting display device includes an anode, a cathode, and an organic light-emitting layer disposed therebetween. As the cathode can be formed using a metal material having a high reflectance, external light is reflected by the metal material which can deteriote visibility due to reflection and can also cause a deterioration in a contrast ratio for images formed in the organic light-emitting display device. Accordingly, in order to reduce reflection or deterioration of visibility or contrast ratio due to external light, a polarizing plate for absorbing external light can be disposed under the cover member. However, the polarizing plate is a film having a predetermined level of light transmittance and absorbs external light and a reflected light thereof to prevent a decrease in the contrast ratio.

Nevertheless, as interest in flexible and slim display devices has increased there is disadvantate is having the polarizing plate which has a certain thickness. In this regard, a display device to which a relatively thin coated polarizing film is applied instead of a thick polarizing plate has been proposed. However, the coated polarizing film also has a problem in that the thickness of the polarizing film is still relatively thick, and when the thickness of the polarizing film is reduced, the function and display quality of the polarizing film are deteriorated.

### SUMMARY OF THE DISCLOSURE

An object of the disclosure is to provide a display device having a structure capable of reducing reflectance of external light in a structure in which a color filter layer is disposed on an encapsulation layer.

Objects of the disclosure are not limited to the above-mentioned objects, and other objects, which are not mentioned above, can be clearly understood by those skilled in the art from the following descriptions.

The obejct is solved by the features of the indepdent claims. Preferred emdoiemnts are given in the depndent claims.

According to an aspect of the disclosure, a display device includes a substrate including a plurality of sub-pixels, a planarization layer disposed on the substrate, and a plurality of light-emitting elements disposed on the planarization layer and including an anode electrode, an organic layer, and a cathode electrode, in which the plurality of sub-pixels includes a first sub-pixel and a second sub-pixel spaced apart from the first sub-pixel, the first sub-pixel includes a first light-emitting area emitting light of a first color, the second sub-pixel includes a second light-emitting area emitting light of a first color, and a height of the planarization layer in the first light-emitting area is different from a height of the planarization layer in the second light-emitting area.

According to antoher asepct a display device is provided, comprising: a substrate including a plurality of sub-pixels; a planarization layer, a bank and an encapsulation layer disposed on the substrate; and a plurality of light-emitting elements disposed on the planarization layer and including an anode electrode, an organic layer, and a cathode electrode, wherein the plurality of sub-pixels includes a first light-emitting area, a second light-emitting area, a first non light-emitting area and a second non-light-emitting area, and wherein thicknesses of at least one of the planarization layer, the bank and the encapsulation layer vary depending on whether a portion of the at least one of the planarization layer, the bank and the encapsulation layer is located in the first light-emitting area, the second light-emitting area, the first non light-emitting area and the second non-light-emitting area.

In the following optional features will be provided which can be combined alone in combination or subcombination with the above mentioned features.

In one or more embodiments, the substrate may include a plurality of pixels.

In one or more embodiments at least one of the plurality of pixels may include a first sub-pixel group, a second sub-pixel group spaced apart from the first sub-pixel group, and a third sub-pixel group spaced apart from the second sub-pixel group.

In one or more embodiments the first sub-pixel group may include the first sub-pixel and the second sub-pixel.

In one or more embodiments, the second sub-pixel group may include a third sub-pixel and a fourth sub-pixel.

In one or more embodiments, the third sub-pixel group may include a fifth sub-pixel and a sixth sub-pixel.

In one or more embodiments the third sub-pixel may include a third light-emitting area configured to emit a second color different from the first color.

In one or more embodiments the fourth sub-pixel may include a fourth light-emitting area configured to emit the second color.

In one or more embodiments the fifth sub-pixel may include a fifth light-emitting area configured to emit a third color different from the first color and the second color.

In one or more embodiments the sixth sub-pixel may include a sixth light-emitting area configured to emit the third color.

In one or more embodiments, a shortest distance from a center of the first light-emitting area to a center of the second light-emitting area may be less than a shortest distance from a center of the first light-emitting area to a center of the third light-emitting area,

In one or more embodiments, a shortest distance from a center of the first light-emitting area to a center of the second light-emitting area may be less than a shortest distance from a center of the fourth light-emitting area from a center of the first light-emitting area,

In one or more embodiments, a shortest distance from a center of the first light-emitting area to a center of the second light-emitting area may be less than a shortest distance from a center of the first light-emitting area to a center of the fifth light-emitting area.

In one or more embodiments, a shortest distance from a center of the first light-emitting area to a center of the second light-emitting area may be less than a shortest distance from a center of the first light-emitting area to a center of the sixth light-emitting area.

In one or more embodiments, the height of the planarization layer in the first light-emitting may be same as heights of the planarization layer in the third light-emitting area and the fifth light-emitting area.

In one or more embodiments, the first color may be red.

In one or more embodiments, the height of the planarization layer in the first light-emitting area may be higher than the height of the planarization layer in the second light-emitting area.

In one or more embodiments, a difference between the height of the planarization layer in the first light-emitting area and the height of the planarization layer in the second light-emitting area may be about 1530 Å to about 1870 Å.

In one or more embodiments, the second color may be green.

In one or more embodiments, and a height of the planarization layer in the third light-emitting area may be higher than a height of the planarization layer in the fourth light-emitting area.

In one or more embodiments, a difference between the height of the planarization layer in the third light-emitting area and the height of the planarization layer in the fourth light-emitting area may be about 1238 Å to about 1512 Å.

In one or more embodiments, the third color may be blue.

In one or more embodiments, a height of the planarization layer in the fifth light-emitting area may be higher than a height of the planarization layer in the sixth light-emitting area.

In one or more embodiments, a difference between the height of the planarization layer in the fifth light-emitting area and the height of the planarization layer in the sixth light-emitting area may be about 1013 Å to about 1237 Å.

In one or more embodiments, the display device may comprise a non-light emitting area each located between the first light-emitting area and the second light-emitting area, between the third light-emitting area and the fourth light-emitting area, and between the fifth light-emitting area and the sixth light-emitting area.

In one or more embodiments, the planarization layer may include at least one first step disposed in the non-light emitting area between the first light-emitting area and the second light-emitting area, at least one second step disposed in the non-light emitting area between the third light-emitting area and the fourth light-emitting area, and at least one third step disposed in the non-light emitting area between the fifth light-emitting area and the sixth light-emitting area.

In one or more embodiments, a height of the first step, a height of the second step, and a height of the third step may be different from each other.

In one or more embodiments, the plurality of light-emitting elements may include a first light-emitting element disposed in the first light-emitting area and a second light-emitting element disposed in the second light-emitting area.

In one or more embodiments, the first light-emitting element may include a first organic layer.

In one or more embodiments, the second light-emitting element may include a second organic layer.

In one or more embodiments, a thickness of the first organic layer and a thickness of the second organic layer may be a same.

In one or more embodiments, the planarization layer may include a first planarization layer and a second planarization layer disposed on the first planarization layer.

In one or more embodiments, the plurality of light-emitting elements may include a first light-emitting element which is disposed on the second planarization layer in the first light-emitting area and may include a first anode electrode.

In one or more embodiments, the plurality of light-emitting elements may include a second light-emitting element disposed on the second planarization layer in the second light-emitting area and may include a second anode electrode.

In one or more embodiments, a first connection electrode may be disposed on the first planarization layer and may be disposed in the first sub-pixe.

In one or more embodiments, a second connection electrode may be spaced apart from the first connection electrode and disposed in the second sub-pixel.

In one or more embodiments, a part of the first connection electrode in the first light-emitting area may overlap the first anode electrode, and the second connection electrode in the second light-emitting area overlaps the second anode electrode.

In one or more embodiments, the display device may comprise a plurality of connection electrode patterns disposed on a same layer as the second connection electrode in the second light-emitting area.

In one or more embodiments, the substrate further may include a first pixel and a second pixel disposed to be adjacent to the first pixel in one direction.

In one or more embodiments, the first pixel may include the first light-emitting area, a third light-emitting area spaced apart from the first light-emitting area, and a fifth light-emitting area.

In one or more embodiments, the second pixel may include the second light-emitting area, a fourth light-emitting area spaced apart from the second light-emitting area, and a sixth light-emitting area.

In one or more embodiments, each of the third light-emitting area and the fourth light-emitting area may be configured to emit light of a second color different from the first color.

In one or more embodiments, each of the fifth light-emitting area and the sixth light-emitting area may be configured to emit light of a third color different from the first color and the second color.

In one or more embodiments, a center distance from a center of the first light-emitting area to a center of the third light-emitting area may be shorter than a center distance from the center of the first light-emitting area to a center of the fourth light-emitting area.

In one or more embodiments, the height of the planarization layer disposed in the first light-emitting area may be a same as heights of the planarization layer disposed in the third light-emitting area and the fifth light-emitting area.

In one or more embodiments, heights of the planarization layer disposed in the second light-emitting area, the fourth light-emitting area, and the sixth light-emitting area may be different from each other.

In one or more embodiments, the heights of the planarization layer disposed in each of the second light-emitting area, the fourth light-emitting area, and the sixth light-emitting area may be lower than the height of the planarization layer disposed in each of the first light-emitting area, the third light-emitting area, and the fifth light-emitting area.

In one or more embodiments, the first color may be red, the second color may be green, and the third color may be blue.

In one or more embodiments, the height of the planarization layer disposed in the second light-emitting area may be lower than the height of the planarization layer disposed in each of the fourth light-emitting area and the sixth light-emitting area.

In one or more embodiments, the height of the planarization layer disposed in the fourth light-emitting area may be lower than the height of the planarization layer disposed in the sixth emission area.

In one or more embodiments, the display device may comprise a non-light emitting area disposed in the first pixel and the second pixel.

In one or more embodiments, in the first pixel, the planarization layer may not include a step in an area in which the non-light emitting area and the first electrode do not overlap.

In one or more embodiments, in the second pixel, the planarization layer may include at least three steps in an area in which the non-light emitting area and the first electrode do not overlap.

In one or more embodiments, the thickness of the planarization layer in the first light-emitting area may be different from thickness the planarization layer in the second light-emitting area.

Other detailed matters of the embodiments are included in the detailed description and the drawings.

According to the example embodiment of the disclosure, the thickness of the planarization layer disposed in the light-emitting areas emitting the same light is different so that external light incident on the display device causes destructive interference, thereby lowering the reflectance of external light and thereby providing an effect of low power driving.

According to the example embodiment of the disclosure, by having a structure in which a difference occurs in thicknesses of components through which external light reflected by anode electrodes disposed to be spaced apart from each other is transmitted, it is possible to provide an effect of preventing a mura phenomenon in which external light is reflected and visually recognized even in a non-driving state.

According to the embodiment of the present disclosure, it is possible to provide a display device capable of adjusting the reflectance of external light in units of pixels.

The effects according to the disclosure are not limited to the contents exemplified above, and more various effects are included in the disclosure.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a schematic block diagram of a display device according to an example embodiment of the disclosure.
FIG. 2 is a plan view schematically illustrating a part of an active area of a display device according to an example embodiment of the disclosure.
FIG. 3 is a cross-sectional view taken along line A-B of FIG. 2.
FIG. 4 is a view schematically illustrating a principle in which external light incident on the display device according to an example embodiment of the disclosure is cancelled.
FIG. 5 is a cross-sectional view taken along the line C-D of FIG. 2.
FIG. 6A is a cross-sectional view of a display device according to another example embodiment of the disclosure.
FIG. 6B is a cross-sectional view of a display device according to another example embodiment of the disclosure.
FIG. 7 is a plan view schematically illustrating a part of an active area of a display device according to still another example embodiment of the present disclosure.
FIG. 8 is a cross-sectional view taken along line E-F of FIG. 7.
FIG. 9 is a cross-sectional view taken along line G-H of FIG. 7.
FIGS. 10A and 10B are views illustrating that a mura phenomenon occurs when the display device according to the comparative example is in a non-driving state.
FIGS. 11A and 11B are views illustrating a state in which a mura phenomenon is improved when the display device according to the embodiment is in a non-driving state.

### DETAILED DESCRIPTION OF THE EMBODIMENTS

Advantages and characteristics of the present disclosure and a method of achieving the advantages and characteristics will be clear by referring to example embodiments described below in detail together with the accompanying drawings. However, the present disclosure is not limited to the example embodiments disclosed herein but will be implemented in various forms. The example embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the example embodiments of the present disclosure are merely examples, and the present disclosure is not limited thereto. Further, in the following description of the present disclosure, a detailed explanation of known related technologies can be omitted to avoid unnecessarily obscuring the subject matter of the present disclosure. The terms such as "including," "having," and "consist of" used herein are generally intended to allow other components to be added unless the terms are used with the term "only". Any references to singular can include plural unless expressly stated otherwise.

Components are interpreted to include an ordinary error range even if not expressly stated.

When the position relation between two parts is described using the terms such as "on", "above", "below", and "next", one or more parts can be positioned between the two parts unless the terms are used with the term "immediately" or "directly".

When an element or layer is disposed "on" another element or layer, another layer or another element can be interposed directly on the other element or therebetween.

Although the terms such as "first", "second", and the like are used for describing various components, these components are not confined by these terms. These terms are merely used for distinguishing one component from the other components and may not define order or sequence. Therefore, a first component to be mentioned below can be a second component in a technical concept of the present disclosure.

Like reference numerals generally denote like elements throughout the disclosure.

A size and a thickness of each component illustrated in the drawing are illustrated for convenience of description, and the present disclosure is not limited to the size and the thickness of the component illustrated. Furhter, the term "can" fully encompasses all the meanings and coverages of the term "may" and vice versa.

The features of various embodiments of the present disclosure can be partially or entirely adhered to or combined with each other and can be interlocked and operated in technically various ways, and the embodiments can be carried out independently of or in association with each other.

Hereinafter, example embodiments of the present disclosure will be described in detail with reference to accompanying drawings.

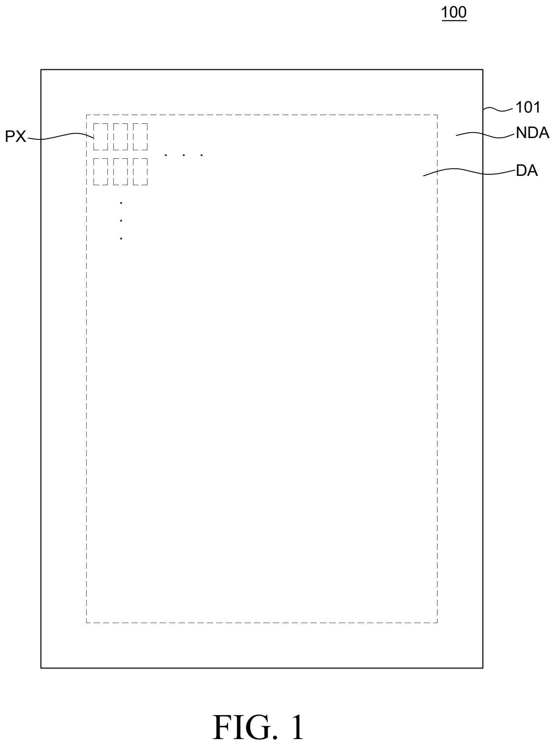

FIG. 1 is a schematic block diagram of a display device according to an example embodiment of the present disclosure. All components of each display device according to all embodiments of the present disclosure are operatively coupled and configured.

Referring to FIG. 1, a display device 100 according to an example embodiment of the present disclosure includes a display element displaying an image, a driving element driving the display element, and a display panel 101 provided with a signal line transmitting various signals to the display element and the driving element.

The display element can be differently defined depending on the type of the display panel 101.

**In** the example embodiment of the present disclosure, it is described as an example that the display panel 101 is an organic light-emitting display panel. In this case, the display element can be an organic light-emitting element including an anode electrode, an organic light-emitting layer, and a cathode.

For example, the display device 100 according to the example embodiment of the present disclosure can be an organic light-emitting display device in which a light-emitting element is implemented as an organic light-emitting element (OLED).

As another example, the display device 100 can be an inorganic light-emitting display device in which the light-emitting element is implemented as a light-emitting element based on an inorganic material.

As another example, the display device 100 can be a quantum dot display device in which a light-emitting element is implemented by a quantum dot which is a self-emitting semiconductor crystal.

Further, the display device 100 according to the example embodiment of the present disclosure can be a flexible organic light-emitting display device.

The display panel 101 can include a substrate, a plurality of insulating films on the substrate, a transistor layer, a light-emitting element layer, and the like.

The display panel 101 can include a plurality of subpixels for displaying an image and various signal lines for driving the plurality of subpixels. The signal line can include a plurality of data lines, a plurality of gate lines, a plurality of power lines, and the like.

A plurality of data lines and a plurality of gate lines disposed in the display panel 101 can cross each other.

Each of the plurality of data lines can be disposed while extending in the first direction. Each of the plurality of gate lines can be disposed while extending in the second direction.

Here, the first direction can be a column direction, and the second direction can be a row direction. Alternatively, the first direction can be a row direction and the second direction can be a column direction.

As illustrated in FIG. 1, the display panel 101 includes a display area DA in which an image is displayed and a non-display area NDA in which an image is not displayed.

In the display area DA, a plurality of pixels PX, a plurality of subpixels constituting the pixel PX, and a pixel circuit for driving the plurality of subpixels can be disposed.

Each of the subpixels can include a transistor positioned on the transistor layer and a light-emitting element positioned on the light-emitting element layer.

The subpixel is a minimum unit constituting the display area DA, and a display element can be disposed in each of the plurality of subpixels.

A pixel circuit for driving a plurality of sub-pixels can be formed of a thin film transistor, a storage capacitor, a gate line, a data line, and the like, but not limited thereto.

The non-display area NDA can be bent, such that the non-display area NDA is not visible from a front surface or can be covered by a case, and referred to as a bezel area.

Various lines and circuits for driving the light-emitting element of the display area DA can be disposed in the non-display area NDA.

For example, in the non-display area NDA, a link line which transmits signals to a plurality of sub pixels and circuits of the display area DA, a gate-in-panel (GIP) line, or a driving IC, such as a gate driver IC or a data driver IC, can be disposed, but it is not limited thereto.

For example, the non-display area NDA can include a ground line which is disposed to surround the display area DA and applies a common voltage to the subpixel. For example, the ground line can be formed as one or two or more, and when two or more ground lines are formed, the ground line positioned closer to the display area DA can be referred to as an internal ground line, but is not limited thereto.

In addition, the display device 100 can include a touch sensing unit including a plurality of touch electrodes. A touch routing line for transmitting a touch signal can be disposed on the plurality of touch electrodes.

In addition, the display device 100 can further include various additional elements for generating various signals or driving the pixels in the display area DA. The additional elements for driving the pixels can include an inverter circuit, a multiplexer, an electrostatic discharge (ESD) circuit, and the like.

Further, the display device 100 can also include an additional element associated with a function other than driving of the pixel PX.

For example, the display device 100 can further include additional elements that provide a touch sensing function, a user authentication function (e.g., fingerprint recognition), a multi-level pressure sensing function, a tactile feedback function, and the like. The above-mentioned additional elements can be located in an external circuit connected to the non-display area NDA and/or the connection interface, but is not limited thereto.

Further, referring to FIG. 1, the display device 100 includes a display driving circuit for driving the display panel 101 and can include a data driving circuit, a gate driving circuit, and a display controller as the display driving circuit.

The data driving circuit is a circuit for driving a plurality of data lines and can output data signals to a plurality of data lines. The gate driving circuit is a circuit for driving a plurality of gate lines and can output gate signals to a plurality of gate lines.

The display controller is a device for controlling a data driving circuit and a gate driving circuit, and can control a driving timing for a plurality of data lines and a driving timing for a plurality of gate lines.

The display controller can supply a data driving control signal to the data driving circuit to control the data driving circuit, and can supply a gate driving control signal to the gate driving circuit to control the gate driving circuit.

The display controller can receive input image data from the host system and supply the image data to the data driving circuit based on the input image data.

The data driving circuit can supply data signals to a plurality of data lines according to driving timing control of the display controller. The data driving circuit can receive digital image data from the display controller, convert the received image data into analog data signals, and output the analog data signals to a plurality of data lines.

The gate driving circuit can supply gate signals to a plurality of gate lines according to timing control of the display controller. The gate driving circuit can be supplied with a first gate voltage corresponding to a turn-on level voltage and a second gate voltage corresponding to a turn-off level voltage together with various gate driving control signals to generate gate signals and supply the generated gate signals to a plurality of gate lines.

The gate driving circuit supplies a gate signal to the gate line according to the gate driving control signal supplied from the display controller. The gate driving circuit can be disposed on one side or both sides of the display panel 101 in a gate in panel (GIP) manner.

The gate driving circuit sequentially outputs the gate signal to a plurality of gate lines under the control of the display controller. The gate driving circuit shifts the gate signal using a shift register to sequentially supply the signals to the gate lines.

The gate signal can include a scan signal and an emission control signal in the display device 100. The scan signal pulse is synchronized with the data voltage to select subpixels of the line on which data is written. The emission control signal defines emission times of each sub-pixel.

At least one of the data driving circuit and the gate driving circuit can be disposed in the display area DA of the display panel 101.

For example, at least one of the data driving circuit and the gate driving circuit can be disposed not to overlap the sub-pixels or can be disposed to partially or entirely overlap the sub-pixels SP, but is not limited thereto.

Further, the display device 100 can further include a power supply circuit which supplies various types of power to the display driving circuit and/or the touch sensing circuit.

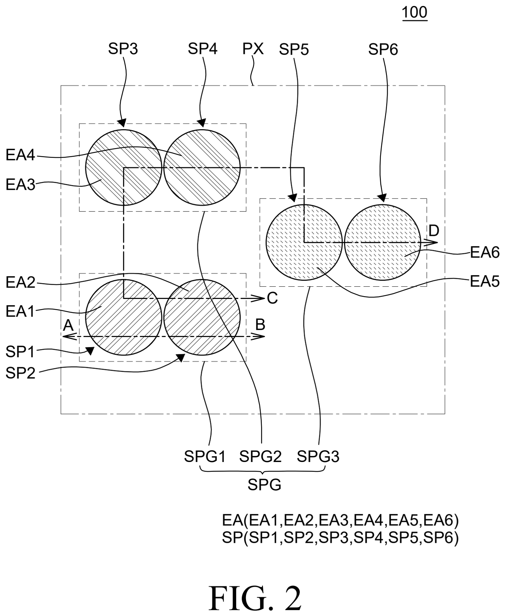

FIG. 2 is a plan view schematically illustrating a part of an active area of a display device according to an example embodiment of the present disclosure.

Referring to FIG. 2, the display area DA of the display device 100 can include a plurality of subpixel groups SPG1, SPG2, and SPG3 included in one pixel PX.

For example, at least one pixel PX disposed in the display area DA can include a first sub-pixel group SPG1, a second sub-pixel group SPG2, and a third sub-pixel group SPG3, but is not limited thereto.

Each sub-pixel group SPG can include a plurality of sub-pixels SP.

For example, the first sub-pixel group SPG1 can include a first sub-pixel SP1 and a second sub-pixel SP2. The second sub-pixel group SPG2 can include a third sub-pixel SP3 and a fourth sub-pixel SP4. The third subpixel group SPG3 can include a fifth subpixel SP5 and a sixth subpixel SP6, but is not limited thereto.

The first sub-pixel SP1 and the second sub-pixel SP2 included in the first sub-pixel group SPG1 can be disposed adjacent to each other.

Further, the third sub-pixel SP3 and the fourth sub-pixel SP4 included in the second sub-pixel group SPG2 can be disposed adjacent to each other.

The fifth sub-pixel SP5 and the sixth sub-pixel SP6 included in the third sub-pixel group SPG3 can be disposed adjacent to each other.

Each of the plurality of subpixels SP can include at least one light-emitting area EA.

For example, the first sub-pixel SP1 can include a first light-emitting area EA1, the second sub-pixel SP2 can include a second light-emitting area EA2, the third sub-pixel SP3 can include a third light-emitting area EA3, the fourth sub-pixel SP4 can include a fourth light-emitting area EA4, the fifth sub-pixel SP5 can include a fifth light-emitting area EA5, and the sixth sub-pixel SP6 can include a sixth light-emitting area EA6, but is not limited thereto.

The plurality of subpixels SP included in one subpixel group SPG can include the light-emitting area EA configured to emit light of the same color.

Specifically, light emitted from the first light-emitting area EA1 of the first sub-pixel SP1 included in the first sub-pixel group SPG1 and light emitted from the second light-emitting area EA2 of the second sub-pixel SP2 included in the first sub-pixel group SPG1 can be light of the same color. For example, each of the first light-emitting area EA1 and the second light-emitting area EA2 can be a light-emitting area that emits red ligh, but is not limited thereto t.

Light emitted from the third light-emitting area EA3 of the third subpixel SP3 included in the second subpixel group SPG2 and light emitted from the fourth light-emitting area EA4 of the fourth subpixel SP4 included in the second subpixel group SPG2 can be light of the same color. For example, each of the third light-emitting area EA3 and the fourth light-emitting area EA4 can be a light-emitting area that emits green light, but is not limited thereto.

Light emitted from the fifth light-emitting area EA5 of the fifth subpixel SP5 included in the third subpixel group SPG3 and light emitted from the sixth light-emitting area EA6 of the sixth subpixel SP6 included in the third subpixel group SPG3 can be light of the same color. For example, each of the fifth light-emitting area EA5 and the sixth light-emitting area EA6 can be a light-emitting area that emits blue light, but is not limited thereto.

The first light-emitting area EA1 of the first sub-pixel SP1 included in the first sub-pixel group SPG1 and the second light-emitting area EA2 of the second sub-pixel SP2 can be disposed adjacent to each other.

Here, the meaning of being adjacent to each other means that the straight shortest distance from the center of the first light-emitting area EA1 of the first sub pixel SP1 to the center of the second light-emitting area EA2 of the second sub pixel SP2 is closer than the straight shortest distance betweeneach center of the first light-emitting area EA1 of the first sub pixel SP1 and the third light-emitting area EA3 of the third sub pixel SP3, the first light-emitting area EA1 of the first sub pixel SP1 and the fourth light-emitting area EA4 of the fourth sub pixel SP4, the fifth light-emitting area EA5 of the first sub pixel SP1 and the sixth light-emitting area EA6 of the first sub pixel SP1.

With reference to FIG. 2, alignments of the adjacent sub pixels SP in the subpixel groups SPG can be the same. For example, the first sub pixel SP1 and the second sub pixel SP2 in the first subpixel group SPG 1 can be aligned horizontally. Such an alignment can be the same in each of the second subpixel group SP2 and the third subpixel group SP3, so that the subpixel groups SPG1, SPG2 and SPG3 can be aligned. But the present disclosure is not limited thereto, and alignements of the sub pixels SP within each subpixel groups SPG can vary from each other, whereby the subpixels SP of a subpixel group SPG can be aligned in an angle relative to those of another subpixel group SPG, or can be aligned perpendicularly to those of the another subpixel group SPG.

Each of the plurality of subpixels SP included in one subpixel group SPG can have a different structure.

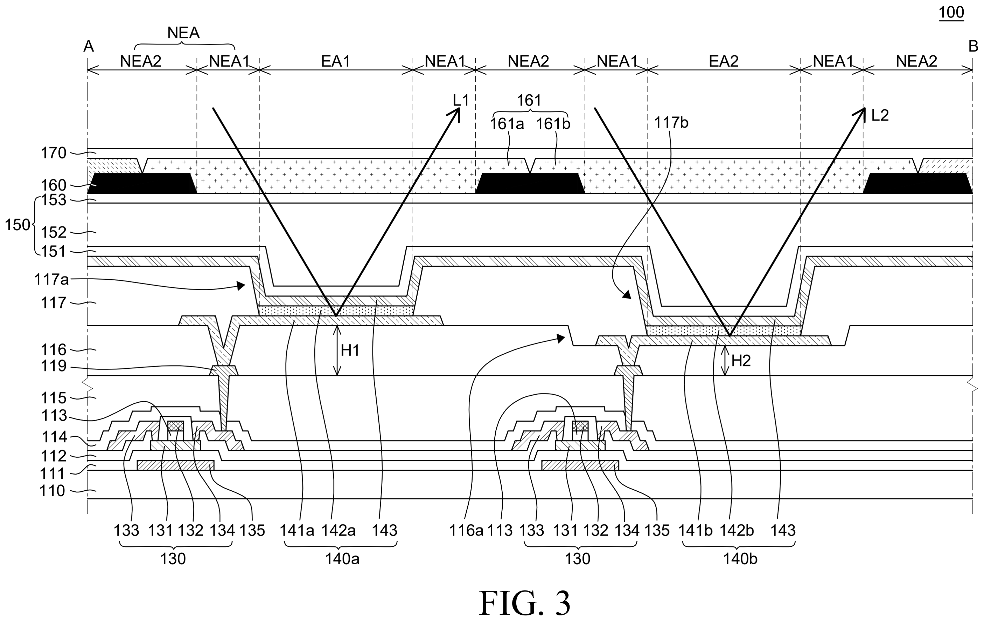

This will be reviewed with reference to FIG. 3 as follows.

FIG. 3 is a cross-sectional view taken along line A-B of FIG. 2.

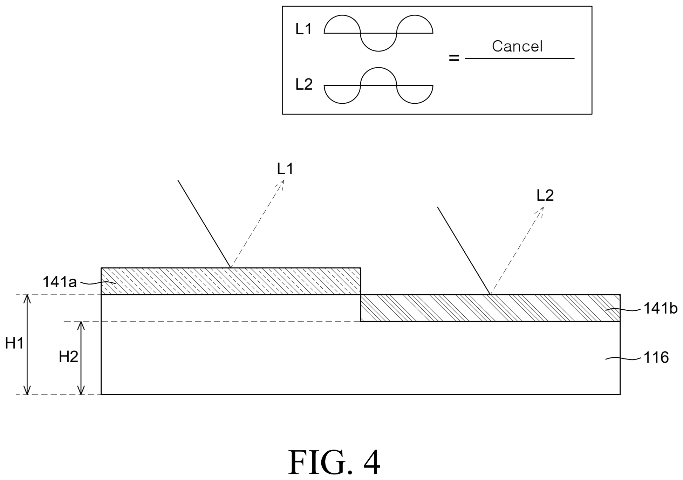

FIG. 4 is a view schematically illustrating a principle in which external light incident on the display device according to an example embodiment of the present disclosure is cancelled.

Referring to FIGS. 3 and 4, a plurality of transistors 130 and a plurality of light-emitting elements 140a and 140b can be disposed on the substrate 110 in the display area DA of the display device 100.

Each of the plurality of transistors 130 can include an active layer 131, a gate electrode 132, a source electrode 134, and a drain electrode 133.

The light-emitting elements 140a and 140b can include a first light-emitting element 140a and a second light-emitting element 140b.

The first light-emitting element 140a can include a first anode electrode 141a, a first organic layer 142a, and a cathode electrode 143, and the second light-emitting element 140b can include a second anode electrode 141b, a second organic layer 142b, and a cathode electrode 143.

Specifically, the light shielding layer 135 can be disposed on the substrate 110.

The light blocking layer 135 can be disposed below the active layer 131 of the transistor 130 to serve as a light shield.

The light blocking layer 135 can be any one of magnesium (Mg), aluminum (Al), nickel (Ni), chromium (Cr), molybdenum (Mo), tungsten (W), gold (Au), titanium (Ti), nickel (Ni), neodymium (Nd), and copper (Cu), or an alloy of two or more, or can be a multilayer thereof, but is not limited thereto. For example, the light blocking layer 135 can be formed of an organic material, but is not limited thereto.

The buffer layer 111 can be disposed on the light shielding layer 135.

The buffer layer 111 can be configured by a single layer of silicon nitride (SiNx) or silicon oxide (SiOx), which is an inorganic material, or a multi-layer of silicon nitride (SiNx) or silicon oxide (SiOx), but is not limited thereto.

The active layer 131 of the transistor 130 can be disposed on the buffer layer 111.

The active layer 131 can be formed of an oxide semiconductor, or can be formed of amorphous silicon (a-Si), polycrystalline silicon (poly-Si), or an organic semiconductor.

A gate insulating film 113 can be disposed on the active layer 131.

The gate insulating film 113 can be configured as a single layer of silicon nitride (SiNx) or silicon oxide (SiOx), which is an inorganic material, or a multilayer of silicon nitride (SiNx) or silicon oxide (SiOx), but is not limited thereto.

The gate electrode 132 can be disposed on the gate insulating film 113.

The gate electrode 132 can be any one of magnesium (Mg), aluminum (Al), nickel (Ni), chromium (Cr), molybdenum (Mo), tungsten (W), gold (Au), titanium (Ti), nickel (Ni), neodymium (Nd), and copper (Cu), or an alloy of two or more, or a multilayer thereof, but is not limited thereto.

The active layer 131 can include a channel region overlapping the gate electrode 132, a first source connection region located at one side of the channel region, and a drain connection region located at the other side of the channel region.

The interlayer insulating layer 112 can be disposed on the substrate 110 on which the gate electrode 132 is disposed.

The interlayer insulating layer 112 can be configured by a single layer of silicon nitride (SiNx) or silicon oxide (SiOx), which is an inorganic material, or a multi-layer of silicon nitride (SiNx) or silicon oxide (SiOx), but is not limited thereto.

The source electrode 134 and the drain electrode 133 can be disposed on the interlayer insulating layer 112.

The source electrode 134 and the drain electrode 133 can be any one of magnesium (Mg), aluminum (Al), nickel (Ni), chromium (Cr), molybdenum (Mo), tungsten (W), gold (Au), titanium (Ti), nickel (Ni), neodymium (Nd), and copper (Cu), or an alloy of two or more, or a multilayer thereof, but are not limited thereto.

The source electrode 134 and the drain electrode 133 can be respectively connected to a source connection region and a drain connection region of the active layer 131 through a contact hole provided in the interlayer insulating layer 112.

A protection layer 114 can be disposed on the source electrode 134 and the drain electrode 133.

The protective layer 114 can be configured as a single layer of silicon nitride (SiNx) or silicon oxide (SiOx) which is an inorganic material, or a multi-layer of silicon nitride (SiNx) or silicon oxide (SiOx), but is not limited thereto.

The first planarization layer 115 can be disposed on the protective layer 114.

A plurality of connection patterns 119 can be disposed on the first planarization layer 115.

Each of the plurality of connection patterns 119 can be connected to the source electrode 134 of the transistor 130 through a contact hole provided in the first planarization layer 115.

The connection pattern 119 can be any one of magnesium (Mg), aluminum (Al), nickel (Ni), chromium (Cr), molybdenum (Mo), tungsten (W), gold (Au), titanium (Ti), nickel (Ni), neodymium (Nd), and copper (Cu), or an alloy of two or more, or a multilayer thereof, but is not limited thereto.

A second planarization layer 116 can be disposed on the connection pattern 119 and the first planarization layer 115.

The first planarization layer 115 and the second planarization layer 116 can include an organic material, protect the transistor 130, and planarize the upper surface of the substrate 110 on which the transistor 130 and the connection pattern 119 are disposed.

A plurality of light-emitting elements 140a and 140b can be disposed on the second planarization layer 116.

Specifically, the first anode electrode 141a and the second anode electrode 141b can be disposed on the second planarization layer 116 to be spaced apart from each other.

The display device 100 according to the example embodiment of the present disclosure is a top emission type in which light emitted from the first light-emitting element 140a and the second light-emitting element 140b is emitted to the upper portion of the substrate 110. Therefore, the first anode electrode 141a and the second anode electrode 141b can include reflective electrode layers.

For example, the first anode electrode 141a and the second anode electrode 141b can each be a single layer including a reflective electrode layer. However, the present disclosure is not limited thereto. The first anode electrode 141a and the second anode electrode 141b can each be configured as a multilayer including a reflective electrode layer.

The reflective electrode layers of the first anode electrode 141a and the second anode electrode 141b can be made of silver (Ag), aluminum (Al), gold (Au), molybdenum (Mo), tungsten (W), chrome (Cr), or an alloy thereof.

Further, when the first anode electrode 141a and the second anode electrode 141b are formed of multiple layers, a transparent conductive layer disposed below the reflective electrode layer or above and below the reflective electrode layer can be further included.

The transparent conductive layer can include, for example, at least one of indium tin oxide (ITO), indium zinc oxide (IZO), or indium gallium zinc oxide (IGZO), but is not limited thereto.

Each of the first anode electrode 141a and the second anode electrode 141b can be connected to different connection electrodes 119 through a contact hole provided in the second planarization layer 116.

A bank 117 can be disposed on a part of an upper surface of each of the first anode electrode 141a and the second anode electrode 141b and a part of an upper surface of the second planarization layer 116.

The bank 117 can be formed of an organic insulating material, but is not limited thereto.

For example, the bank 117 can include a black-colored organic insulating material. Accordingly, external light incident on the bank 117 from the outside of the display device 100 is absorbed to reduce the reflectance of external light, but is not limited thereto.

However, in some cases, the bank 117 can include a transparent organic insulating material or a transparent inorganic insulating material, but in the following description, it is exemplified that the bank 117 includes a black organic insulating material.

The bank 117 can be disposed to cover edges of the first anode electrode 141a and the second anode electrode 141b.

The bank 117 can include a plurality of bank holes 117a and 117b. Each of the plurality of bank holes 117a and 117b can be disposed to overlap a part of an upper surface of one anode electrode.

The bank 117 can include a first bank hole 117a and a second bank hole 117b.

The first bank hole 117a can overlap a part of a top surface of the first anode electrode 141a, and the second bank hole 117b can overlap a part of a top surface of the second anode electrode 141b.

For example, a part of the top surface of each of the first anode electrode 141a and the second anode electrode 141b can be exposed by the first bank hole 117a and the second bank hole 117b.

An area in which each of the plurality of bank holes 117a and 117b is disposed can be the light-emitting area EA of the subpixel SP.

For example, the area in which the first bank hole 117a is disposed can be an area corresponding to the first light-emitting area EA1 of the first sub-pixel SP1, but is not limited thereto.

The area in which the second bank hole 117b is disposed can be an area corresponding to the second light-emitting area EA2 of the second sub-pixel SP2.

An area which is not overlapped with the plurality of bank holes 117a and 117b can be the non light-emitting area NEA.

The non-light emitting area NEA can include a first non-light emitting area NEA1 and a second non-light emitting area NEA2.

The first non light-emitting area NEA1 can be an area surrounding one light-emitting area EA. The first non light-emitting area NEA1 can be an area overlapping the bank 117 and overlapping the first color filter layer 161 disposed on the bank 117.

The second non-light emitting area NEA2 can be an area that surrounds the plurality of first non-light emitting areas NEA1. The second non light-emitting area NEA2 can be an area overlapping the bank 117 and overlapping the black matrix 160 disposed on the bank 117.

The bank 117 is disposed in the plurality of first non-light emitting areas NEA1 and the second non-light emitting area NEA2 so that among the external light incident on the display device 100, the external light incident on the bank 117 can be absorbed by the bank.

Accordingly, there is an effect of lowering the reflectance of external light in the first non light-emitting area NEA1 and the second non light-emitting area NEA2. In particular, the bank 117 can absorb external light incident on the first non-light emitting area NEA1 overlapping the first color filter layer 161 and lower the reflectance of external light in the first non-light emitting area NEA1, thereby enabling low power driving of the display device.

A plurality of organic layers 142a and 142b can be disposed on a part of a top surface of each of the first anode electrode 141a and the second anode electrode 141b.

Specifically, the first organic layer 142a can be disposed on a part of the top surface of the first anode electrode 141a, and the second organic layer 142b can be disposed on a part of the top surface of the second anode electrode 141b.

The first organic layer 142a can be disposed in an area overlapping the first bank hole 171a, and the second organic layer 142b can be disposed in an area overlapping the second bank hole 171b.

Each of the first organic layer 142a and the second organic layer 142b includes a light-emitting layer and can be configured by a multi-layer.

The first organic layer 142a and the second organic layer 142b can have the same thickness.

The cathode electrode 143 can be disposed on the first organic layer 142a, the second organic layer 142b, and the bank 117.

The cathode electrode 143 can be formed of a metal alloy such as MgAg, an ytterbium (Yb) alloy, or a transparent conductive material such as indium tin oxide (ITO), indium zinc oxide (IZO), or can further include a metal doping layer, but is not limited thereto.

The first light-emitting element 140a and the second light-emitting element 140b can share the same cathode electrode 143.

The encapsulation layer 150 can be disposed on the cathode electrode 143.

The encapsulation layer 150 can have a single layer structure or a multi-layer structure. For example, the encapsulation layer 150 can include a first encapsulation layer 151, a second encapsulation layer 152, and a third encapsulation layer 153, but is not limited thereto.

The first encapsulation layer 151 and the third encapsulation layer 153 can be configured by inorganic films, and the second encapsulation layer 152 can be configured by an organic film. Among the first encapsulation layer 151, the second encapsulation layer 152, and the third encapsulation layer 153, the second encapsulation layer 152 is the thickest and can serve as a planarization layer.

The first encapsulation layer 151 can be disposed on the cathode electrode 143 and can be disposed to be most adjacent to the light-emitting element 130.

The first encapsulation layer 151 can be formed along a surface shape of the cathode electrode 143. Therefore, the surface of the first encapsulation layer 151 in the bank hole 117a or 117b of the bank 117 can be non-flat.

The first encapsulation layer 151 can be formed of an inorganic insulating material on which low-temperature deposition can be performed. For example, the first encapsulation layer 151 can be made of silicon nitride (SiNx), silicon oxide (SiOx), silicon oxynitride (SiON), or aluminum oxide

(Al₂O₃), but is not limited thereto. Since the first encapsulation layer 151 is deposited under a low temperature atmosphere, it is possible to prevent the organic layer 142a or 142b of the light-emitting element 140a or 140b including an organic material vulnerable to the high temperature atmosphere from being damaged during the deposition process.

The second encapsulation layer 152 can be made of an organic insulating material such as acrylic resin, epoxy resin, polyimide, polyethylene, or silicon oxy carbon (SiOC). For example, the second encapsulation layer 152 can be formed by an inkjet method, but is not limited thereto.

Further, a structure which blocks a flow of the second encapsulation layer 152 constituting the encapsulation layer 150 can be disposed in the non-display area NDA. In order to prevent the encapsulation layer 150 from collapsing, one or more structures can be disposed at an end point of the inclined surface of the encapsulation layer 150 or in the vicinity of the inclined surface of the encapsulation layer 150.

The one or more structures can be disposed at a boundary point between the display area DA and the non-display area NDA or in the vicinity of the boundary point. The structure can be formed of at least one layer made of an organic material, and for example, can include a lower layer formed of the same material on the same layer as the second planarization layer 116 and an upper layer formed of the same material on the same layer as the bank 117, but is not limited thereto.

The third encapsulation layer 153 can be formed above the substrate 110 on which the second encapsulation layer 152 is formed so as to cover upper surfaces and side surfaces of the second encapsulation layer 152 and the first encapsulation layer 151.

In this case, the third encapsulation layer 153 can minimize or block the permeation of external moisture or oxygen into the first encapsulation layer 151 and the second encapsulation layer 152. For example, the third encapsulation layer 153 can be made of an inorganic insulating material, such as silicon nitride (SiNx), silicon oxide (SiOx), silicon oxynitride (SiON), or aluminum oxide (Al₂O₃), but is not limited thereto.

The black matrix 160 and the first color filter layer 161 can be disposed on the third encapsulation layer 153.

Since the black matrix 160 and the first color filter layer 161 are disposed on the third encapsulation layer 153, the thickness of the display device 100 can be reduced, and the transmittance can be easily adjusted, such that external light and reflected light can be absorbed without lowering the luminous efficiency, thereby improving the display quality.

The first color filter layer 161 can serve to convert a wavelength of light emitted from the first light-emitting element 140a and the second light-emitting element 140b into a specific wavelength.

For example, each of the first light-emitting area EA1 and the second light-emitting area EA2 is an area which emits red light so that light emitted from the first light-emitting element 140a and the second light-emitting element 140b can be converted into red light by the first color filter layer 161, but is not limited thereto.

The first color filter layer 161 can include a first sub-color filter layer 161a and a second sub-color filter layer 161b.

The first sub-color filter layer 161a can overlap the first anode electrode 141a, the first organic layer 142a, and the cathode electrode 143 of the first light-emitting element 140a in the first light-emitting area EA1.

Further, the first sub-color filter layer 161a can overlap the first anode electrode 141a of the first light-emitting element 140a, a part of the bank 117, and the cathode electrode 143 of the first light-emitting element 140a in the first non light-emitting area NEA1 surrounding the first light-emitting area EA1.

The second sub-color filter layer 161b can overlap the second anode electrode 141b, the second organic layer 142b, and the cathode electrode 143 of the second light-emitting element 140b in the second light-emitting area EA2.

Further, the second sub-color filter layer 161b can overlap the second anode electrode 141b of the second light-emitting element 140b, a part of the bank 117, and the cathode electrode 143 of the second light-emitting element 140b in the first non light-emitting area NEA1 surrounding the second light-emitting area EA2.

However, FIG. 3 illustrates a structure in which the first sub-color filter layer 161a is disposed in the first non light-emitting area NEA1 which encloses the first light-emitting area EA1 and the first light-emitting area EA1 and the second sub-color filter layer 161b is disposed in the first non light-emitting area NEA1 which encloses the second light-emitting area EA2 and the second light-emitting area EA2. However, the present disclosure is not limited thereto.

For example, one first color filter layer 161 can be disposed in the first non-light emitting area NEA1 which encloses the first light-emitting area EA1 and the first light-emitting area EA1 and can also be disposed in the second light-emitting area EA2 and the first non-light emitting area NEA1 which encloses the second light-emitting area EA2, but is not limited thereto.

Meanwhile, when viewers watch the display device 100, they may not only look at the display device 100 from the front surface of the display device 100, but also look at the display device 100 from the side surface of the display device 100.

Accordingly, the display device 100 needs to ensure a viewing angle characteristic so that the quality of the image does not deteriorate even when viewed from the side as well as the front surface of the display device 100.

In the display device 100 according to the example embodiment of the present disclosure, in order to secure viewing angle characteristics, the first sub-color filter layer 161a can be disposed not only in the first light-emitting area EA1 but also in the first non light-emitting area NEA1 surrounding the first light-emitting area EA1, and the second sub-color filter layer 161b can be disposed not only in the second light-emitting area EA2 but also in the first non light-emitting area NEA1 surrounding the second light-emitting area EA2.

An overcoat layer 170 for flattening an upper surface can be disposed on the black matrix 160 and the first color filter layer 161.

Meanwhile, since the black matrix 160 is not disposed in the first non-light emitting area NEA1, an area in which the black matrix 160 can absorb external light is reduced, which can cause a problem in that the reflectance of external light of the display device 100 increases.

In particular, even in the non-driving state of the display device 100, external light is reflected by the first anode electrode 141a including a reflective electrode layer and the second anode electrode 141b to cause diffraction, which can cause a mura phenomenon that is perceived by the naked eye. For example, a plurality of circles of rainbow light can be visually recognized, or a shape in which the lines of rainbow light intersect can be visually recognized, but is not limited thereto.

Accordingly, in the display device 100 according to the example embodiment of the present disclosure, the first height H1 of the second planarization layer 116 disposed in the first light-emitting area EA1 and the second height H2 of the second planarization layer 116 disposed in the second light-emitting area EA2 are different, so that external light incident into the display device 100 may not be emitted again to the outside of the display device 100 through destructive interference. Accordingly, reflectance of external light of the display device 100 can be lowered, and low power driving of the display device 100 can be possible.

Specifically, the first height H1 of the second planarization layer 116 disposed in the first light-emitting area EA1 can be higher than the second height H2 of the second planarization layer 116 disposed in the second light-emitting area EA2.

In order for the second planarization layer 116 to have different heights in each of the first light-emitting area EA1 and the second light-emitting area EA2, the second planarization layer 116 can include at least one first step 116a in the non light-emitting area NEA.

For example, the first step 116a of the second planarization layer 116 can be disposed in the second non-light emitting area NEA1, and the first step 116a of the second planarization layer 116 can overlap the bank 117, but is not limited thereto.

The first step 116a may not overlap the first anode electrode 141a or the second anode electrode 141b of the light-emitting elements 140a and 140b.

Therefore, each of the first anode electrode 141a and the second anode electrode 141b is disposed in a flat area above the second planarization layer 116, such that the first anode electrode 141a and the second anode electrode 141b can be easily connected to the connection pattern 119 disposed below the second planarization layer 116.

However, the present disclosure is not limited thereto, and in some cases, the first step 116a of the second planarization layer 116 can be disposed in the first non-light emitting area NEA1.

The first anode electrode 141a of the first light-emitting element 140a can be disposed farther from the top surface of the first planarization layer 115 than the second anode electrode 141b of the second light-emitting element 140b.

Specifically, the minimum distance from the rear surface of the first anode electrode 141a disposed in the first light-emitting area EA1 to the top surface of the first planarization layer 115 can be longer than the minimum distance from the rear surface of the second anode electrode 141b disposed in the second light-emitting area EA2 to the top surface of the first planarization layer 115.

Meanwhile, among the external light incident to the first sub-pixel SP1, the first external light L1 incident to the first anode electrode 141a through the first sub-color filter 161a, the encapsulation layer 150, the cathode electrode 143, and the first organic layer 142a is reflected by the first anode electrode 141a including a reflective electrode layer to be emitted through the first organic layer 142a, the cathode electrode 143, the encapsulation layer 150, and the first sub-color filter 161a.

In addition, among the external light incident to the second sub-pixel SP2, the second external light L2 incident to the second anode electrode 141b is reflected by the second anode electrode 141b including the reflective electrode layer through the second sub-color filter 161b, the encapsulation layer 150, the cathode electrode 143, and the second organic layer 142b to be emitted through the second organic layer 142b, the cathode electrode 143, the encapsulation layer 150, and the second sub-color filter 161a.

Here, the thickness of the second encapsulation layer 152 disposed in the area in which the second planarization layer 116 has the first height H1 can be smaller than the thickness of the second encapsulation layer 152 disposed in the area in which the second planarization layer 116 has the second height H2.

Further, a minimum distance from the top surface of the first anode electrode 141a of the first light-emitting element 140a disposed in the first light-emitting area EA1 to the top surface of the first sub-color filter layer 161a can be shorter than a minimum distance from the top surface of the second anode electrode 141b of the second light-emitting element 140b disposed in the second light-emitting area EA2 to the top surface of the second sub-color filter layer 161b.

The difference between the first height H1 of the second planarization layer 116 and the second height H2 of the second planarization layer 116 can be designed such that the first external light L1 reflected by the first anode electrode 141a and the second external light L2 reflected by the second anode electrode 141b have a phase difference of 180°.

Specifically, the difference between the first height H1 of the second planarization layer 116 and the second height H2 of the second planarization layer 116 can be determined in consideration of the arrangement of the first light-emitting element 140a and the second light-emitting element 140b that emit red light in the first light-emitting area EA1 and the second light-emitting area EA2.

For example, the difference between the first height H1 of the second planarization layer 116 and the second height H2 of the second planarization layer 116 can be 1530 Å to 1870 Å, but is not limited thereto. When the difference between the first height H1 and the second height H2 is out of the range of 1530 Å to 1870 Å, wavelengths of external light emitted from the first light-emitting area EA1 and the second light-emitting area EA2 are not offset by each other, so that the external light reflectance of the display device 100 can increase.

By varying the height of the first height H1 of the second planarization layer 116 disposed in an area overlapping at least a portion of the first anode electrode 141a and the height of the second height H2 of the second planarization layer 116 disposed in an area overlapping at least a portion of the second anode electrode 141b, each of the first external light L1 and the second external light L2 can have different thicknesses of configurations (matrix) transmitted after entering the display device 100.

Specifically, the difference in thickness of the components through which each of the first external light L1 and the second external light L2 passes can be nλ/4 times. Here, n can be an odd number greater than 0.

For example, the difference in thickness of the components through which each of the first external light L1 and the second external light L2 passes can be variously formed by λ/4 times, 3λ/4 times, 5λ/4 times, and the like. For example, a difference in thickness of the second encapsulation layer 152 through which the first external light L1 and the second external light L2 pass can occur due to a difference in height of the second planarization layer 116. The difference in thickness of the second encapsulation layer 152 through which each of the first external light L1 and the second external light L2 passes can varyly formed in λ/4 times, 3λ/4 times, 5λ/4 times, and the like, but is not limited thereto.

In particular, the difference between the first height H1 of the second planarization layer 116 and the second height H2 of the second planarization layer 116 is formed to be 1530 Å to 1870 Å, so that the difference in thickness of the components through which each of the first external light L1 and the second external light L2 passes can be λ/4 times.

Accordingly, the first external light L1 and the second external light L2 cause destructive interference and are not emitted to the outside of the display device 100.

Accordingly, it is possible to improve the image level of the display device 100 by preventing a mura phenomenon in which external light is reflected and visually recognized even in the non-driving state of the display device 100.

Further, in the display device 100 according to the example embodiment of the present disclosure, the first sub pixel SP1 having a first height H1 and the second sub pixel SP2 having a second height H2 are disposed to be adjacent to each other, such that the first external light L1 and the second external light L2 can be offset without dispersion of each of the first external light L1 and the second external light L2.

On the contrary, when the first sub-pixel SP1 having the first height H1 and the second sub-pixel SP2 having the second height H2 are disposed to be far away from each other, a canceling effect of the first external light L1 and the second external light L2 can be degraded.

In addition, when the height of another component disposed on the anode electrode is adjusted so that the first external light L1 and the second external light L2 cause destructive interference, the characteristics of the display device 100 can be deteriorated.

For example, when the thickness of the first organic layer 142a disposed on the first anode electrode 141a and the second organic layer 142b disposed on the second anode electrode 141b is adjusted, light with a wavelength other than a desired wavelength can be emitted in the first light-emitting area EA1 and the second light-emitting area EA2, or light emission characteristics can be deteriorated.

Accordingly, the thicknesses of the first organic layer 141a and the second organic layer 142b can be designed to be the same.

Further, when the height of the cathode electrode 143 disposed on the first anode electrode 141a and the second anode electrode 141b is adjusted, the cathode resistance value varies for each position so that the luminous efficiency can vary for each sub pixel SP. Accordingly, since the luminance characteristic varies according to the location, a defect of the display device 100 can occur.

In addition, when the height of the first encapsulation layer 151 or the third encapsulation layer 153 disposed on the first anode electrode 141a and the second anode electrode 141b is adjusted, a moisture penetration issue can occur in one part.

For example, in the display device 100 according to the example embodiment of the present disclosure, the second planarization layer 116 is formed with the first height H1 below the first anode electrode 141a and the second height H2 below the second anode electrode 141b so that the phase difference of 180° between the first external light L1 and the second external light L2 can be offset from each other.

With reference to FIGS. 3 and 4, thicknesses of portions of the encapsulation layer 150, including the first encapsulation layer 151, the second encapsulation layer 152, and the third encapsulation layer 153, can be the same or vary depending on whether a location of the portions of the encapsulation layer 150 is located at one of the first light-emitting area EA1, the second light-emitting area EA2, the first non light-emitting area NEA1 or the second non light-emitting area NEA2. For example, for the encapsulation layer 150, a thickness thereof in the first light-emitting area EA1 is different from that in the second light-emitting area EA2, as well as those in the first and second non light-emitting areas NEA1 and NEA2. For example, the thickness of the encapsulation layer 150 in the first light-emitting area EA1 less than that in the second light-emitting area EA2, but greater than that in the first or the second non light-emitting area NEA1 or NEA2.

Also, thicknesses of portions of the bank 117 can be the same or vary depending on whether a location of the portions of the bank 117 is located at one of the first light-emitting area EA1, the second light-emitting area EA2, the first non light-emitting area NEA1 or the second non light-emitting area NEA2. For example, a portion of the bank 117 in the second non light-emitting area NEA2 can be less than a portion of the bank 117 in the first non light-emitting area NEA2, which can be side-by-side or sepearated.

Also, thicknesses of portions of the second planarization layer 116 can be the same or vary depending on whether a location of the portions of the second planarization layer is located at one of the first light-emitting area EA1, the second light-emitting area EA2, the first non light-emitting area NEA1 or the second non light-emitting area NEA2.

Accordingly, a mura phenomenon does not occur even in the non-driving state of the display device 100, and an image level in the non-driving state of the display device 100 can be improved.

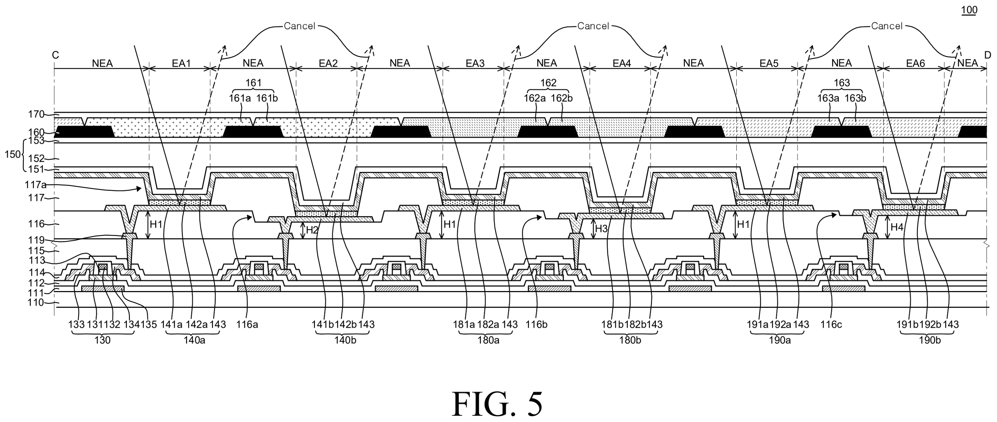

Next, referring to FIG. 5, structures of the second sub-pixel group SPG2 and the third sub-pixel group SPG3 as well as the first sub-pixel group SPG1 are reviewed as follows.

FIG. 5 is a cross-sectional view taken along the line C-D of FIG. 2.

Referring to FIG. 5, a plurality of transistors 130 and a plurality of light-emitting elements 140a, 140b, 180a, 180b, 190a, 190b can be disposed on the substrate 110 in the display area DA of the display device 100.

Each of the plurality of light-emitting elements 140a, 140b, 180a, 180b, 190a, and 190b can be electrically connected to at least one transistor 130.

The plurality of light-emitting elements 140a, 140b, 180a, 180b, 190a, 190b can include a first light-emitting element 140a, a second light-emitting element 140b, a third light-emitting element 180a, a fourth light-emitting element 180b, a fifth light-emitting element 190a, and a sixth light-emitting element 190b.

The first light-emitting element 140a can be disposed in the first light-emitting area EA1, the second light-emitting element 140b can be disposed in the second light-emitting area EA2, the third light-emitting element 180a can be disposed in the third light-emitting area EA3, the fourth light-emitting element 180b can be disposed in the fourth light-emitting area EA4, the fifth light-emitting element 190a can be disposed in the fifth light-emitting area EA5, and the sixth light-emitting element 190b can be disposed in the sixth light-emitting area EA6.

A first color filter layer 161 can be disposed in the first light-emitting area EA1 and the second light-emitting area EA2, a second color filter layer 162 can be disposed in the third light-emitting area EA3 and the fourth light-emitting area EA4, and a third color filter layer 163 can be disposed in the fifth light-emitting area EA5 and the sixth light-emitting area EA6.

The first color filter layer 161 can serve to convert light emitted from the first light-emitting element 140a and the second light-emitting element 140b into red light.

The first color filter layer 161 can include a first sub-color filter layer 161a and a second sub-color filter layer 161b.

The second color filter layer 162 can serve to convert light emitted from the third light-emitting element 180a and the fourth light-emitting element 180b into green light.

The second color filter layer 162 can include a third sub-color filter layer 162a and a fourth sub-color filter layer 162b.

The third color filter layer 163 can serve to convert light emitted from the fifth light-emitting element 190a and the sixth light-emitting element 190b into blue light.

The third color filter layer 163 can include a fifth sub-color filter layer 163a and a seventh sub-color filter layer 163b.

Each of the first sub-color filter layer 161a, the second sub-color filter layer 161b, the third sub-color filter layer 162a, the fourth sub-color filter layer 162b, the fifth sub-color filter layer 163a, and the sixth sub-color filter layer 163b can be disposed on the third encapsulation layer 153.

Further, referring to FIG. 5, each of the first sub-color filter layer 161a, the second sub-color filter layer 161b, the third sub-color filter layer 162a, the fourth sub-color filter layer 162b, the fifth sub-color filter layer 163a, and the sixth sub-color filter layer 163b can be disposed in a part of the non-light emitting area NEA and can also overlap a part of the bank 117 in the non-light emitting area NEA.

The first light-emitting element 140a can include a first anode electrode 141a, a first organic layer 142a, and a cathode electrode 143, and the second light-emitting element 140b can include a second anode electrode 141b, a second organic layer 142b, and a cathode electrode 143.

The third light-emitting element 180a can include a third anode electrode 181a, a third organic layer 182a, and a cathode electrode 143, and the fourth light-emitting element 180b can include a fourth anode electrode 181b, a fourth organic layer 182b, and a cathode electrode 143.

The fifth light-emitting element 190a can include a fifth anode electrode 191a, a fifth organic layer 192a, and a cathode electrode 143, and the sixth light-emitting element 190b can include a sixth anode electrode 191b, a sixth organic layer 192b, and a cathode electrode 143.

On the second planarization layer 116, the first anode electrode 141a, the second anode electrode 141b, the third anode electrode 181a, the fourth anode electrode 181b, the fifth anode electrode 191a, and the sixth anode electrode 191b can be disposed to be spaced apart from each other.

Each of the first anode electrode 141a, the second anode electrode 141b, the third anode electrode 181a, the fourth anode electrode 181b, the fifth anode electrode 191a, and the sixth anode electrode 191b can include a reflective electrode layer.

For example, each of the first anode electrode 141a, the second anode electrode 141b, the third anode electrode 181a, the fourth anode electrode 181b, the fifth anode electrode 191a, and the sixth anode electrode 191b can be a single layer including a reflective electrode layer, but is not limited thereto and can be configured by a multi-layer including a reflective electrode layer.

The reflective electrode layers of the first anode electrode 141a, the second anode electrode 141b, the third anode electrode 181a, the fourth anode electrode 181b, the fifth anode electrode 191a, and the sixth anode electrode 191b can be made of silver (Ag), aluminum (Al), gold (Au), molybdenum (Mo), tungsten (W), chromium (Cr), or an alloy thereof.

In addition, when the first anode electrode 141a, the second anode electrode 141b, the third anode electrode 181a, the fourth anode electrode 181b, the fifth anode electrode 191a, and the sixth anode electrode 191b are configured as a multilayer, a transparent conductive layer disposed below the reflective electrode layer or above and below the reflective electrode layer can be further included.

The transparent conductive layer can include, for example, at least one of indium tin oxide (ITO), indium zinc oxide (IZO), or indium gallium zinc oxide (IGZO), but is not limited thereto.

In the display device 100 according to the example embodiment of the present disclosure, the first height H1 of the second planarization layer 116 disposed in the first light-emitting area EA1 of the first sub pixel SP1 included in the first sub pixel group SPG1 and the second height H2 of the second planarization layer 116 disposed in the second light-emitting area EA2 of the second sub pixel SP2 can be different from each other.

In addition, the first height H1 of the second planarization layer 116 disposed in the third light-emitting area EA3 of the third sub-pixel SP3 included in the second sub-pixel group SPG2 can be different from the third height H3 of the second planarization layer 116 disposed in the fourth light-emitting area EA4 of the fourth sub-pixel SP4.

In addition, the first height H1 of the second planarization layer 116 disposed in the fifth light-emitting area EA5 of the fifth sub-pixel SP5 included in the third sub-pixel group SPG3 can be different from the fourth height H4 of the second planarization layer 116 disposed in the sixth light-emitting area EA6 of the sixth sub-pixel SP6.

Specifically, the height of the second planarization layer 116 disposed in the light-emitting area EA of at least one of the subpixels SP included in each of the first subpixel group SPG1, the second subpixel group SPG2, and the third subpixel group SPG3 can be the same.

For example, the height of the second planarization layer 116 disposed in the first light-emitting area EA1 of the first sub-pixel SP1 included in the first sub-pixel group SPG1, the height of the second planarization layer 116 disposed in the third light-emitting area EA3 of the third sub-pixel SP3 included in the second sub-pixel group SPG2, and the height of the second planarization layer 116 disposed in the fifth light-emitting area EA5 of the fifth sub-pixel SP5 included in the third sub-pixel group SPG3 can all be the same as the first height H1.

Further, the first height H1 of the second planarization layer 116 disposed in the first light-emitting area EA1 can be higher than the second height H2 of the second planarization layer 116 disposed in the second light-emitting area EA2.

In order for the second planarization layer 116 to have different heights in each of the first light-emitting area EA1 and the second light-emitting area EA2, the second planarization layer 116 can include at least one first step 116a in the non light-emitting area NEA.

The difference between the first height H1 of the second planarization layer 116 and the second height H2 of the second planarization layer 116 can be designed so that the external light reflected by the first anode electrode 141a and the external light reflected by the second anode electrode 141b have a phase difference of 180°.

Specifically, the difference between the first height H1 of the second planarization layer 116 and the second height H2 of the second planarization layer 116 can be determined in consideration of the arrangement of the first light-emitting element 140a and the second light-emitting element 140b that emit red light in the first light-emitting area EA1 and the second light-emitting area EA2.

For example, the difference between the first height H1 of the second planarization layer 116 and the second height H2 of the second planarization layer 116 can be 1530 Å to 1870 Å, but is not limited thereto. When the difference between the first height H1 and the second height H2 is out of the range of 1530 Å to 1870 Å, external light emitted from the first light-emitting area EA1 and the second light-emitting area EA2 is not offset so that the reflectance of external light of the display device 100 can increase.

Accordingly, the external light reflected by the first anode electrode 141a and the external light reflected by the second anode electrode 141b can cause destructive interference, and are not emitted to the outside of the display device 100.

In addition, the first height H1 of the second planarization layer 116 disposed in the third light-emitting area EA3 can be higher than the third height H3 of the second planarization layer 116 disposed in the fourth light-emitting area EA4.

In order for the second planarization layer 116 to have different heights in each of the third light-emitting area EA3 and the fourth light-emitting area EA4, the second planarization layer 116 can include at least one second step 116b in the non light-emitting area NEA.

The second step 116b may not overlap the third anode electrode 181a or the fourth anode electrode 181b of the light-emitting elements 180a and 180b.

Therefore, each of the third anode electrode 181a and the fourth anode electrode 181b is disposed in a flat area above the second planarization layer 116, such that the third anode electrode 181a and the fourth anode electrode 181b can be easily connected to the connection pattern 119 disposed below the second planarization layer 116.

However, the present disclosure is not limited thereto, and in some cases, the second step 116b of the second planarization layer 116 can be disposed to overlap the second color filter layer 162 and the bank 117.

The third anode electrode 181a of the third light-emitting element 180a can be disposed farther from the top surface of the first planarization layer 115 than the fourth anode electrode 181b of the fourth light-emitting element 180b.

Specifically, the minimum distance from the rear surface of the third anode electrode 181a disposed in the third light-emitting area EA3 to the upper surface of the first planarization layer 115 can be longer than the minimum distance from the rear surface of the fourth anode electrode 181b disposed in the fourth light-emitting area EA4 to the upper surface of the first planarization layer 115.

In addition, a minimum distance from the top surface of the third anode electrode 181a of the third light-emitting element 180a disposed in the third light-emitting area EA3 to the top surface of the third sub color filter layer 162a can be shorter than a minimum distance from the top surface of the fourth anode electrode 181b of the fourth light-emitting element 180b disposed in the fourth light-emitting area EA4 to the top surface of the fourth sub color filter layer 162b.

The difference between the first height H1 of the second planarization layer 116 and the third height H3 of the second planarization layer 116 can be designed so that the external light reflected by the third anode electrode 181a and the external light reflected by the fourth anode electrode 181b have a phase difference of 180°.

Specifically, the difference between the first height H1 of the second planarization layer 116 and the third height H3 of the second planarization layer 116 can be determined in consideration of the disposition of the third light-emitting element 180a and the fourth light-emitting element 180b which emit green light in the third light-emitting area EA3 and the fourth light-emitting area EA4.

For example, the difference between the first height H1 of the second planarization layer 116 and the third height H3 of the second planarization layer 116 can be 1238 Å to 1512 Å, but is not limited thereto. When the difference between the first height H1 and the second height H2 is out of the range of 1238 Å to 1512 Å, wavelengths of external light emitted from the third light-emitting area EA3 and the fourth light-emitting area EA4 are not offset by each other, so that the external light reflectance of the display device 100 can increase.

By varying the height of the first height H1 of the second planarization layer 116 disposed in an area overlapping at least a portion of the third anode electrode 181a and the height H3 of the second planarization layer 116 disposed in an area overlapping at least a portion of the fourth anode electrode 181b, the thickness of the components (matrix) through which external light incident on the display device 100 passes is changed. For example, the thickness of the second encapsulation layer 152, among the components through which external light incident on the display device 100 passes, can vary.

Specifically, a difference in thickness of components through which each of the external light reflected by the third anode electrode 181a and the external light reflected by the fourth anode electrode 181b passes can be nλ/4 times. Here, n can be an odd number greater than 0.

In particular, the difference between the first height H1 of the second planarization layer 116 and the third height H3 of the second planarization layer 116 is formed to be 1238 Å to 1512 Å, so that the difference in thickness of the components through which each of the external light reflected by the third anode electrode 181a and the external light reflected by the fourth anode electrode 181b passes can be λ/4 times.

Accordingly, the external light reflected by the third anode electrode 181a and the external light reflected by the fourth anode electrode 181b cause destructive interference and are not emitted to the outside of the display device 100.

In addition, the first height H1 of the second planarization layer 116 disposed in the fifth light-emitting area EA5 can be higher than the fourth height H4 of the second planarization layer 116 disposed in the sixth light-emitting area EA6.

In order for the second planarization layer 116 to have different heights in each of the fifth light-emitting area EA5 and the sixth light-emitting area EA6, the second planarization layer 116 can include at least one third step 116c in the non light-emitting area NEA.

The third step 116c may not overlap the fifth anode electrode 191a or the sixth anode electrode 191b of the light-emitting elements 190a and 190b.

Therefore, each of the fifth anode electrode 191a and the sixth anode electrode 191b is disposed in a flat area above the second planarization layer 116, such that the fifth anode electrode 191a and the sixth anode electrode 191b can be easily connected to the connection pattern 119 disposed below the second planarization layer 116.

However, the present disclosure is not limited thereto, and in some cases, the third step 116c of the second planarization layer 116 can be disposed to overlap the third color filter layer 163 and the bank 117.

The fifth anode electrode 191a of the fifth light-emitting element 190a can be disposed farther from the top surface of the first planarization layer 115 than the sixth anode electrode 191b of the sixth light-emitting element 190b.

Specifically, the minimum distance from the rear surface of the fifth anode electrode 191a disposed in the fifth light-emitting area EA5 to the top surface of the first planarization layer 115 can be longer than the minimum distance from the rear surface of the sixth anode electrode 191b disposed in the sixth light-emitting area EA6 to the top surface of the first planarization layer 115.

Further, a minimum distance from the top surface of the fifth sub-color filter layer 163a of the fifth light-emitting element 190a disposed in the fifth light-emitting area EA5 to the top surface of the fifth sub-color filter layer 163a can be shorter than a minimum distance from the top surface of the sixth anode electrode 191b of the sixth light-emitting element 190b disposed in the sixth light-emitting area EA6 to the top surface of the sixth sub-color filter layer 163b.

The difference between the first height H1 of the second planarization layer 116 and the fourth height H4 of the second planarization layer 116 can be designed so that the external light reflected by the fifth anode electrode 191a and the external light reflected by the sixth anode electrode 191b have a phase difference of 180°.

Specifically, a difference between the first height H1 of the second planarization layer 116 and the fourth height H4 of the second planarization layer 116 can be determined in consideration of the disposition of the fifth light-emitting element 190a and the sixth light-emitting element 190b which emit blue light in the fifth light-emitting area EA5 and the sixth light-emitting area EA6.

For example, the difference between the first height H1 of the second planarization layer 116 and the fourth height H4 of the second planarization layer 116 can be 1013 Å to 1237 Å, but is not limited thereto. When the difference between the first height H1 and the fourth height H4 is out of the range of 1013 Å to 1237 Å, wavelengths of external light emitted from the fifth light-emitting area EA5 and the sixth light-emitting area EA6 are not offset by each other, so that the external light reflectance of the display device 100 can increase.

By varying the height of the first height H1 of the second planarization layer 116 disposed in an area overlapping at least a portion of the fifth anode electrode 191a and the height of the fourth height H4 of the second planarization layer 116 disposed in an area overlapping at least a portion of the sixth anode electrode 191b, the thickness of the components (matrix) through which external light incident on the display device 100 passes is changed. For example, the thickness of the second encapsulation layer 152, among the components through which external light incident on the display device 100 passes, can vary.

Specifically, a difference in thickness of components through which each of the external light reflected by the fifth anode electrode 191a and the external light reflected by the sixth anode electrode 191b passes can be nλ/4 times. Here, n can be an odd number greater than 0.

In particular, the difference between the first height H1 of the second planarization layer 116 and the fourth height H4 of the second planarization layer 116 is formed to be 1013 Å to 1237 Å, so that the difference in thickness of the components through which the external light reflected by the fifth anode electrode 191a and the external light reflected by the sixth anode electrode 191b pass can be λ/4 times.

Accordingly, the external light reflected by the fifth anode electrode 191a and the external light reflected by the sixth anode electrode 191b cause destructive interference and are not emitted to the outside of the display device 100.

Further, in the display device 100 according to the example embodiment of the present disclosure, the second height H2 of the second planarization layer 116, the third height H3 of the second planarization layer 116, and the fourth height H4 of the second planarization layer 116 can be different.

Specifically, the second height H2 of the second planarization layer 116 disposed in the second light-emitting area EA2 emitting red light can be lower than the third height H3 of the second planarization layer 116 disposed in the fourth light-emitting area EA4 emitting green light and the fourth height H4 of the second planarization layer 116 disposed in the sixth light-emitting area EA6 emitting blue light.

Accordingly, the height of the first step 116a, the height of the second step 116b, and the height of the third step 116c disposed in the non light-emitting area NEA can be different from each other.

Here, the height of the first step 116a, the height of the second step 116b, and the height of the third step 116c can mean a minimum length in the direction in which the buffer layer 111 is stacked on the substrate 110.

For example, the subpixel group SPG included in the display device 100 according to the embodiment of the present disclosure can include the plurality of subpixels SP. The plurality of subpixels SP included in the same subpixel group SPG can include the light-emitting area EA configured to emit light with the same color.

Further, one subpixel group SPG can include two subpixels SP. In each of the two sub-pixels SP, the height of the second planarization layer 116 can be different for each light-emitting area EA.

For example, when external light is incident on the light-emitting area EA included in one subpixel SP and external light is incident on the light-emitting area EA included in the other subpixel SP, even if the external light is reflected by the anode electrodes disposed in each light-emitting area EA, the external light reflectance of the display device 100 can be reduced due to destructive interference.

Specifically, the height of the second planarization layer 116 in one subpixel group SPG can be adjusted to have a phase difference of 180° when external light incident on the light-emitting areas EA included in different subpixels SP is reflected by the anode electrode.

In addition, since the external light reflectance can be adjusted in units of pixels PX of the display device 100, there is an effect that even the external light reflectance can be finely adjusted.

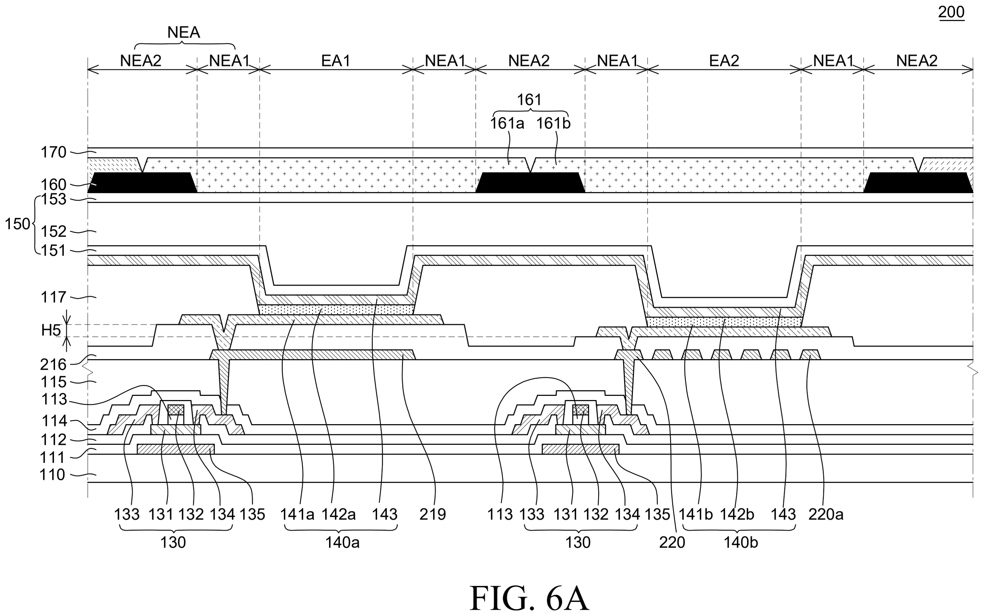

FIG. 6A is a cross-sectional view of a display device according to another example embodiment of the present disclosure.

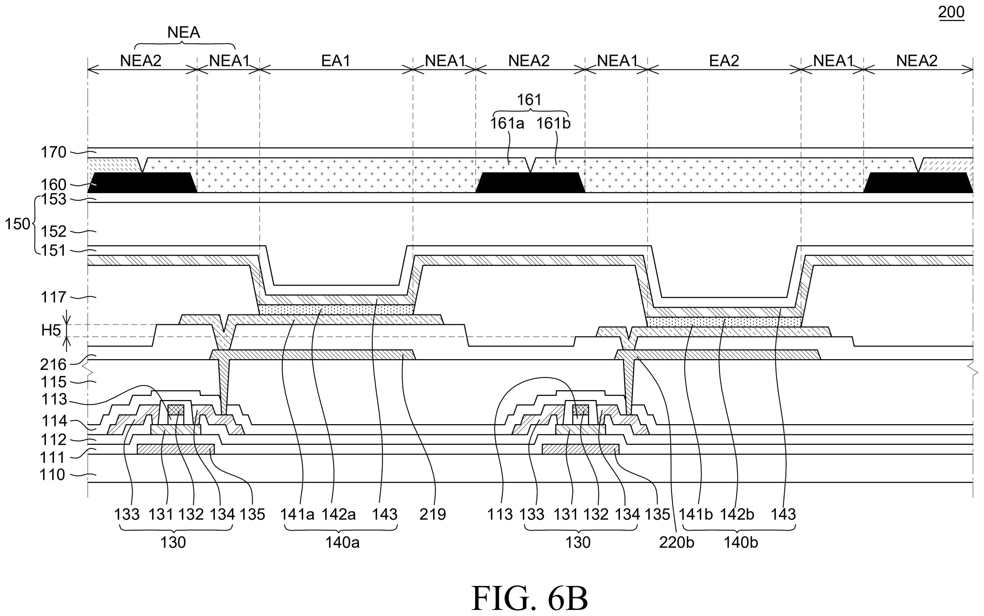

FIG. 6B is a cross-sectional view of a display device according to another example embodiment of the present disclosure.

The only difference between a display device 200 of FIGS. 6A and 6B and the display device 100 of FIG. 3 is a structure of a second planarization layer 216 and connection electrodes 219, 220, and 220b, but other components are substantially the same, so that a redundant description will be omitted.

First, referring to FIG. 6A, the first planarization layer 115 of the display device 200 can be disposed on a plurality of transistors.

A plurality of connection electrodes 219 and 220 can be disposed on the first planarization layer 115.

For example, the plurality of connection electrodes 219 and 220 can include a first connection electrode 219 and a second connection electrode 220.

The first connection electrode 219 can serve to electrically connect the first anode electrode 141a of the first light-emitting element 140a to the transistor 130.

The second connection electrode 220 can serve to electrically connect the second anode electrode 141b of the second light-emitting element 140b to the other transistor 130.

An area in which the first connection electrode 219 overlaps the first anode electrode 141a can be wider than an area in which the second connection electrode 220 overlaps the second anode electrode 141b.

The first connection electrode 219 can be disposed in at least a part of the first light-emitting area EA1 and at least a part of the first non-light emitting area NEA1. In addition, in some cases, the first connection electrode 219 can also be disposed in a part of the second non light-emitting area NEA2.

The second connection electrode 219 can be disposed in the first non light-emitting area NEA1. In addition, in some cases, the second connection electrode 219 can also be disposed in a portion of the second non light-emitting area NEA2.

A plurality of connection electrode patterns 220a can be disposed on the first planarization layer 115.

The plurality of connection electrode patterns 220a can include the same material as the first connection electrode 219 and the second connection electrode 220.

In cross section, the plurality of connection electrode patterns 220a can be disposed on the first planarization layer 115 to be spaced apart from each other.

At least a part of the pattern of the plurality of connection electrodes 220a can be disposed in at least a part of the second light-emitting area EA2. Further, at least some of the plurality of connection electrodes 220a can also be disposed in the first non-light emitting area NEA1 which encloses the second light-emitting area EA2. In some cases, at least some of the plurality of connection electrodes 220a can also be disposed in a part of the second non light-emitting area NEA2.

A second planarization layer 216 can be disposed on the first connection electrode 219, the second connection electrode 220, and the plurality of connection electrode patterns 220a.

The second planarization layer 216 can include an inorganic insulating material. For example, the second planarization layer 216 can be configured by a single layer of silicon nitride (SiNx) or silicon oxide (SiOx) or a multi-layer of silicon nitride (SiNx) or silicon oxide (SiOx), but is not limited thereto.

In some cases, the second planarization layer 216 can include an organic insulating material.

The second planarization layer 216 can include a plurality of steps generated by the first connection electrode 219, the second connection electrode 220, and the plurality of connection electrode patterns 220a.

Specifically, the second planarization layer 216 can be formed along a surface shape morphology of the components disposed below the second planarization layer 216.

In particular, a thickness of the second planarization layer 216 in an area overlapping the first connection electrode 219 extending to at least a part of the first light-emitting area EA1 can be greater than a thickness of the second connection electrode 220 disposed to be spaced apart from each other and the second planarization layer 216 in an area overlapping the plurality of connection electrode patterns 220a.

Therefore, the height difference H5 of the second planarization layer 216 can occur in the area in which the first connection electrode 219 is disposed and in the area in which the second connection electrode 220 and the plurality of connection electrode patterns 220a are disposed.

A height difference H5 of the second planarization layer 216 occurs between an area in which the first connection electrode 219 is disposed and an area in which the second connection electrode 220 and the plurality of connection electrode patterns 220a are disposed. Therefore, an external light reflected by the first anode electrode 141a, among external light incident on the display device 200, and an external light reflected by the second anode electrode 141b, among external light incident on the display device 200, transmits through different thicknesses of configurations (matrix) of the display device 200. For example, the thickness of the second encapsulation layer 152, among the components through which external light incident on the display device 100 passes, can vary, but is not limited thereto.

Specifically, the difference in thickness of the components through which the external light reflected by the first anode electrode 141a and the external light reflected by the second anode electrode 141b pass can be nλ/4 times. Here, n can be an odd number greater than 0.

For example, the difference in thickness of the components through which the external light reflected by the first anode electrode 141a and the external light reflected by the second anode electrode 141b pass can be variously formed as λ/4 times, 3λ/4 times, 5λ/4 times, and the like, but is not limited thereto.

For example, the height difference H5 of the second planarization layer 216 can be 1530 Å to 1870 Å, but is not limited thereto, and thus, the difference between the external light reflected by the first anode electrode 141a and the external light reflected by the second anode electrode 141b can be λ/4 times, but is not limited thereto.

The external light reflected by the first anode electrode 141a and the external light reflected by the second anode electrode 141b cause destructive interference and are not emitted to the outside of the display device 200.

Accordingly, it is possible to improve the image level of the display device 200 by preventing the mura phenomenon in which external light is reflected and visually recognized even in the non-driving state of the display device 200.

In FIG. 6A, a structure in which the height difference H5 of the second planarization layer 216 occurs is illustrated because the area in which the first connection electrode 219 overlaps the first anode electrode 141a is wider than the area in which the plurality of connection electrode patterns 220a overlaps the second anode electrode 141b. However, the structure of the display device 200 according to another example embodiment of the present disclosure is not limited thereto.

For example, as illustrated in FIG. 6B, the second connection electrode 220b is disposed to overlap the second anode electrode 141b, and the height of the second connection electrode 220b is made lower than the height of the first connection electrode 219, which can cause a height difference H5 of the second planarization layer 216.

Alternatively, the height of the first connection electrode 219 and the height of the second connection electrode 220b are the same, but the height of the second planarization layer 216 disposed on the first connection electrode 219 is formed to be higher than the height of the second planarization layer 216 disposed on the second connection electrode 220, such that the height difference H5 of the second planarization layer 216 can occur.

In FIGS. 6A and 6B, the structure of the first sub-pixel group SPG1 is described as an example, but the structure of the display device 200 according to another example embodiment of the present disclosure is not limited thereto.

Specifically, the structure of FIG. 6A or FIG. 6B can also be applied to at least one subpixel group SPG among the second subpixel group SPG2 and the third subpixel group SPG3.

However, in the second sub-pixel group SPG2, the height difference H5 of the second planarization layer 216 can be formed to be 1238 Å to 1512 Å, and accordingly, the difference in thickness of the components between the external light reflected by the first anode electrode 141a and the external light reflected by the second anode electrode 141b can be λ/4 times.

The height difference H5 of the second planarization layer 216 in the second sub-pixel group SPG2 can be set in consideration of the disposition of a light-emitting element emitting green light.

Further, in the third sub-pixel group SPG3, the height difference H5 of the second planarization layer 216 can be 1013 Å to 1237 Å, and accordingly, the difference in thickness of each of the components of the external light reflected by the first anode electrode 141a and the external light reflected by the second anode electrode 141b can be λ/4 times.

The height difference H5 of the second planarization layer 216 in the third subpixel group SPG3 can be set in consideration of disposing a light-emitting element emitting blue light.

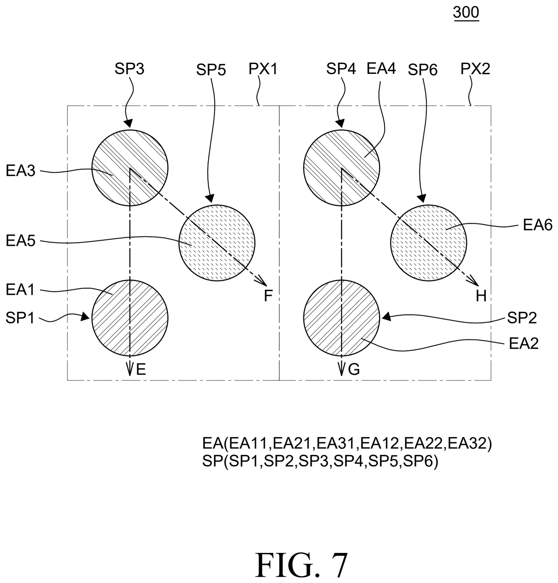

Next, a structure of the display device 300 according to still another example embodiment of the present disclosure will be reviewed with reference to FIG. 7 as follows.

FIG. 7 is a plan view schematically illustrating a part of an active area of a display device according to still another example embodiment of the present disclosure.

Referring to FIG. 7, in the display device 300, a plurality of pixels PX1 and PX2 can be disposed in the display area DA.

A plurality of pixels PX1 and PX2 can include a first pixel PX1 and a second pixel PX2.

The first pixel PX1 and the second pixel PX2 can be pixels disposed adjacent to each other with respect to one direction.

Each of the first pixel PX1 and the second pixel PX2 can include a plurality of sub-pixels SP.

For example, the first pixel PX1 can include a first sub pixel SP1, a third sub pixel SP3, and a fifth sub pixel SP5, but is not limited thereto.

The second pixel PX2 can include a second sub-pixel SP2, a fourth sub-pixel SP4, and a sixth sub-pixel SP6, but is not limited thereto.

Each of the plurality of subpixels SP can include at least one light-emitting area EA.

For example, the first sub-pixel SP1 can include a first light-emitting area EA1, the second sub-pixel SP2 can include a second light-emitting area EA2, the third sub-pixel SP3 can include a third light-emitting area EA3, the fourth sub-pixel SP4 can include a fourth light-emitting area EA4, the fifth sub-pixel SP5 can include a fifth light-emitting area EA5, and the sixth sub-pixel SP6 can include a sixth light-emitting area EA6, but is not limited thereto.

The light-emitting areas EA of the plurality of sub pixels SP included in one pixel PX can be light-emitting areas EA that emit light of different colors.

For example, the first light-emitting area EA1 and the second light-emitting area EA2 can be light-emitting areas which emit red light.

The third light-emitting area EA3 and the fourth light-emitting area EA4 can be light-emitting areas that emit green light.

The fifth light-emitting area EA5 and the sixth light-emitting area EA6 can be light-emitting areas that emit blue light.

In addition, the first light-emitting area EA1 of the first sub-pixel SP1 included in the first pixel PX1 and the second light-emitting area EA2 of the second sub-pixel SP2 included in the second pixel PX2 can be disposed side by side with respect to one direction.

The third light-emitting area EA3 of the third sub-pixel SP3 included in the first pixel PX1 and the fourth light-emitting area EA4 of the fourth sub-pixel SP4 included in the second pixel PX2 can be disposed side by side with respect to one direction.

The fifth light-emitting area EA5 of the fifth sub-pixel SP5 included in the first pixel PX1 and the sixth light-emitting area EA6 of the sixth sub-pixel SP6 included in the second pixel PX2 can be disposed side by side with respect to one direction.

External light emitted from at least one light-emitting area EA disposed in the first pixel PX1 and external light emitted from at least one light-emitting area EA disposed in the second pixel PX2 disposed adjacent to the first pixel PX1 can cause destructive interference with each other, preventing the external light emitted to the outside of the display device 100.

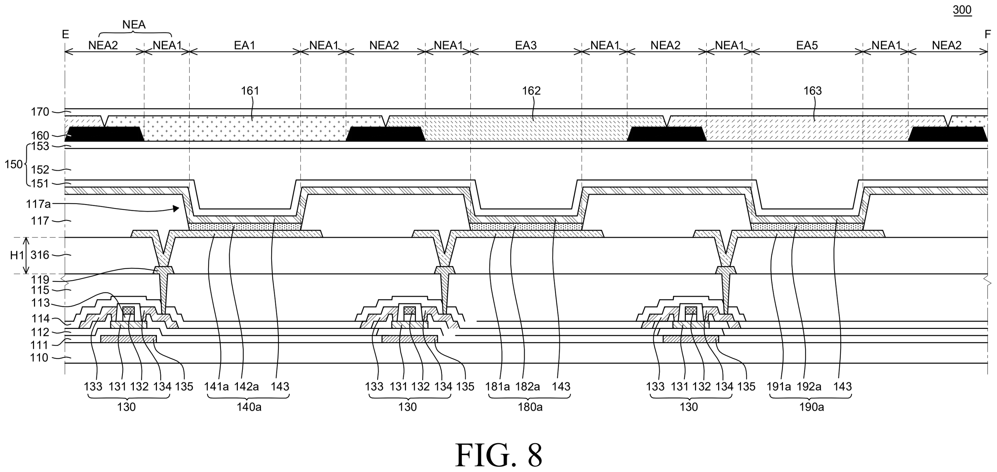

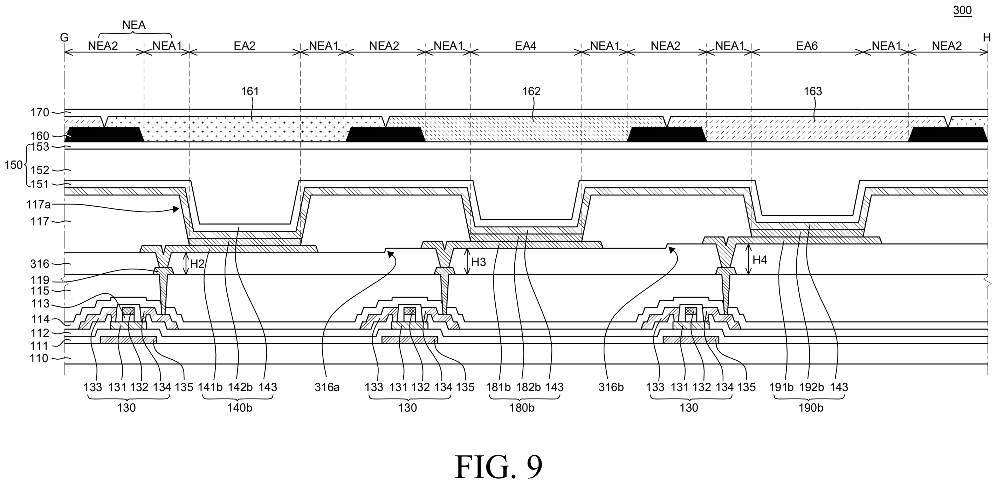

The structures of the first pixel PX1 and the second pixel PX2 will be described below with reference to FIGS. 8 and 9.

FIG. 8 is a cross-sectional view taken along line E-F of FIG. 7.

FIG. 9 is a cross-sectional view taken along line G-H of FIG. 7.

In FIGS. 8 and 9, compared to the display device 100 of FIGS. 3 and 5, the arrangement of sub-pixels is different, and only the drawing numbers of the sub-pixels and light-emitting areas are different according to the change in the arrangement of sub-pixels, but other components are substantially the same, so that a redundant description will be omitted.

Referring to FIGS. 8 and 9, the first pixel PX1 of the display device 300 can include the first light-emitting area EA1 of the first sub pixel SP1, the third light-emitting area EA3 of the third sub pixel SP3, and the fifth light-emitting area EA5 of the fifth sub pixel SP5.

The first light-emitting element 140a can be disposed in the first light-emitting area EA1, the third light-emitting element 180a can be disposed in the third light-emitting area EA3, and the fifth light-emitting element 190a can be disposed in the fifth light-emitting area EA5.

The structure of the first light-emitting area EA1 of FIG. 8 is substantially the same as the structure of the first light-emitting area EA1 of FIGS. 3 and 5, the structure of the third light-emitting area EA3 is substantially the same as the structure of the third light-emitting area EA3 of FIG. 5, and the structure of the fifth light-emitting area EA5 can be substantially the same as the structure of the fifth light-emitting area EA5 of FIG. 5.

Referring to FIGS. 8 and 9, the second pixel PX2 of the display device 300 can include a second light-emitting area EA2 of the second sub pixel SP2, a fourth light-emitting area EA4 of the fourth sub pixel SP4, and a sixth light-emitting area EA6 of the sixth sub pixel SP6.

The second light-emitting element 140b can be disposed in the second light-emitting area EA2, the fourth light-emitting element 180b can be disposed in the fourth light-emitting area EA4, and the sixth light-emitting element 190b can be disposed in the sixth light-emitting area EA6.

The structure of the second light-emitting area EA2 of FIG. 9 is substantially the same as the structure of the second light-emitting area EA2 of FIGS. 3 and 5, the structure of the fourth light-emitting area EA4 is substantially the same as the structure of the fourth light-emitting area EA4 of FIG. 5, and the structure of the sixth light-emitting area EA6 can be substantially the same as the structure of the sixth light-emitting area EA6 of FIG. 5.

Referring to FIGS. 8 and 9, a second planarization layer 316 disposed on the connection electrode 119 can be disposed in the first pixel PX1 of the display device 300.

The thickness of the second planarization layer 316 can be different for each area.

For example, in the first pixel PX1, the second planarization layer 316 can have a first thickness H1.

For example, in each of the first light-emitting area EA1, the third light-emitting area EA3, and the fifth light-emitting area EA5 included in the first pixel PX1, the second planarization layer 316 can have the same thickness.

In the second pixel PX2 of the display device 300, the second planarization layer 316 can include at least two steps 316a and 316b disposed in the non light-emitting area NEA.

At least two steps 316a and 316b of the second planarization layer 316 positioned in the second pixel PX2 can be positions at which the height of the second planarization layer 316 is changed in the non light-emitting area NEA.

In the second pixel PX2 of the display device 300, the second planarization layer 316 can include a portion having a second thickness H2, a portion having a third thickness H3, and a portion having a fourth thickness H4.

Specifically, in at least a part of the second sub pixel SP2 in the second pixel PX2 of the display device 300, the second planarization layer 316 can have a second thickness H2.

For example, in the second sub-pixel SP2, the second planarization layer 316 disposed below the second anode electrode 141b can have a second thickness H2. Here, the second planarization layer 316 disposed below the second anode electrode 141b can have a second thickness H2, except for a portion where a contact hole through which the second anode electrode 141b is connected to the connection electrode 119 is formed in the second planarization layer 316.

In particular, the second thickness H2 of the second planarization layer 316 can be different from the first thickness H1 of the second planarization layer 316 disposed in the first sub-pixel SP1 of the first pixel PX1.

Specifically, the first thickness H1 of the second planarization layer 316 can be greater than the second thickness H2 of the second planarization layer 316. Here, the difference between the first thickness H1 of the second planarization layer 316 and the second thickness H2 of the second planarization layer 316 can be 1530 Å to 1870 Å.

Accordingly, the difference in thickness of the components between the external light reflected by the first anode electrode 141a disposed in the first pixel PX1 and the external light reflected by the second anode electrode 141b disposed in the second pixel PX2 can be λ/4 times.

However, the present disclosure is not limited to the structure of the display device 300 according to the example embodiment of the present disclosure.

For example, the difference between the first thickness H1 of the second planarization layer 316 and the second thickness H2 of the second planarization layer 316 can vary, but is not limited thereto.

In this case, the difference between the first thickness H1 and the second thickness H2 can be changed so that the thickness of the components through which each of the external light reflected by the first anode electrode 141a and the external light reflected by the second anode electrode 141b passes can be nλ/4 times. Here, n can be an odd number greater than 0.

The external light reflected by the first anode electrode 141a disposed in the first pixel PX1 and the external light reflected by the second anode electrode 141b disposed in the second pixel PX2 cause destructive interference and are not emitted to the outside of the display device 300.

Further, the first pixel PX1 and the second pixel PX2 are disposed adjacent to each other, such that external light incident on each of the first sub pixel SP1 and the second sub pixel SP2 including an light-emitting area EA which emits light of the same color can be offset by using an destructive interference phenomenon, and the external light reflectance of the display device 300 can be lowered.

Further, the heights of the first light-emitting area EA1 which emits light of the same color among the plurality of light-emitting areas EA included in the first pixel PX1 and the second pixel PX2 are adjusted to adjust the heights of the second planarization layer 316 disposed in the second light-emitting area EA2. Therefore, each of the external light reflected by the first anode electrode 141a after being incident to the first light-emitting area EA1 and the external light reflected by the second anode electrode 141b after being incident to the second light-emitting area EA2 can have a phase difference of 180°.

In particular, since the first light-emitting area EA1 and the second light-emitting area EA2 are light-emitting areas EA that emit light of the same color, thicknesses of the first organic layer 142a disposed in the first light-emitting area EA1 and the second organic layer 142b disposed in the second light-emitting area EA2 can be the same.

In contrast, in the display device 300 according to still another example embodiment of the present disclosure, the heights of the first light-emitting area EA1 which emits light of the same color among the plurality of light-emitting areas EA included in the first pixel PX1 and the second pixel PX2 and the second planarization layer 316 disposed in the second light-emitting area EA2 are adjusted to design each having a phase difference of 180° between the external light reflected by the first anode electrode 141a after being incident to the first light-emitting area EA1 and the external light reflected by the second anode electrode 141a after being incident to the second light-emitting area EA2, thereby reducing the design error and maintaining the luminous efficiency of the light-emitting element.

In addition, the first pixel PX1 and the second pixel PX2 are disposed adjacent to each other, such that external light incident on each of the third sub pixel SP3 and the fourth sub pixel SP4 including the light-emitting area EA which emits light of the same color can be offset by using an offset interference phenomenon, and the external light reflectance of the display device 300 can be lowered.

Further, the first pixel PX1 and the second pixel PX2 are disposed to be adjacent to each other, such that external light incident on each of the fifth sub pixel SP3 and the sixth sub pixel SP6 including the light-emitting area EA which emits light of the same color can be cancelled by an destructive interference phenomenon and the external light reflectance of the display device 300 can be lowered.

The display device 300 according to still another example embodiment of the present disclosure can include a first pixel PX1 and a second pixel PX2 disposed to be adjacent to each other with respect to one direction.

The second planarization layer 316 disposed in the first pixel PX1 can have a first height H1.

The second planarization layer 316 disposed in the second pixel PX2 can include a portion having a second height H2, a portion having a third height H3, and a portion having a fourth height H4.

In the first pixel PX1, a part of the portion where the second planarization layer 316 has the first height H1 can be disposed in each of the first light-emitting area EA1, the third light-emitting area EA3, and the fifth light-emitting area EA5.

In the second pixel PX1, a part of the portion where the second planarization layer 316 has the second height H2 can be disposed in the second light-emitting area EA2, a part of the portion where the second planarization layer 316 has the third height H3 can be disposed in the fourth light-emitting area EA4, and a part of the portion where the second planarization layer 316 has the fourth height H4 can be disposed in the sixth light-emitting area EA6.

Further, by adjusting the height difference of the second planarization layer 316 disposed in the light-emitting areas emitting light of the same color among the plurality of light-emitting areas EA included in the first pixel PX1 and the second pixel PX2, the phase difference of the external light incident on each of the first pixel PX1 and the second pixel PX2 can be 180°, thereby canceling the external light incident on the display device 300 by using the destructive interference phenomenon.

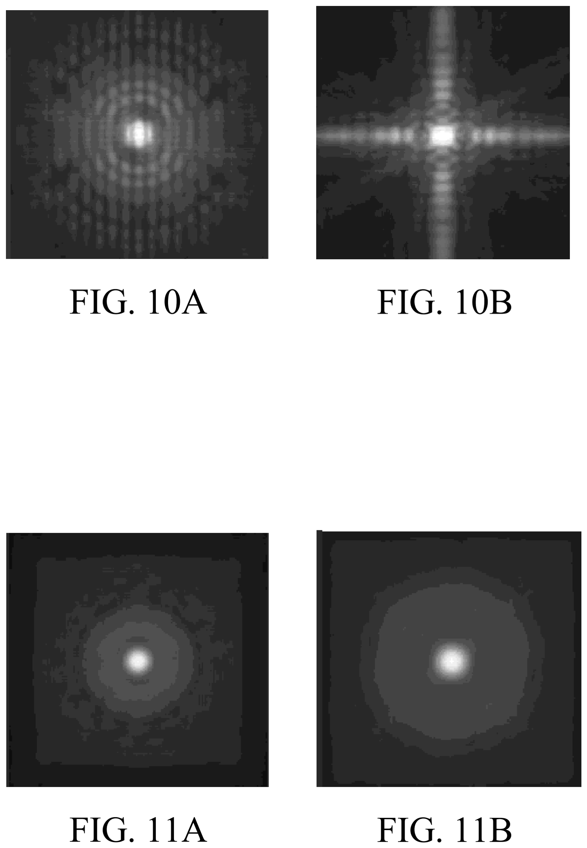

FIGS. 10A and 10B are views illustrating that a mura phenomenon occurs when the display device according to the comparative example is in a non-driving state.

FIGS. 11A and 11B are views illustrating a state in which a mura phenomenon is improved when the display device according to the embodiment is in a non-driving state.

The display device according to the comparative example of FIGS. 10A and 10B is a display device in which the height of the second planarization layer does not change.

The display device according to the embodiment of FIGS. 11A and 11B is the display device illustrated in FIGS. 2 to 5.

Referring to FIGS. 10A and 10B, it can be seen that when the display device according to the comparative example is in a non-driving state, external light is reflected by the anode electrode including the reflective electrode layer, and diffraction occurs, resulting in a mura phenomenon that is visually recognized.

Specifically, when the display device according to the comparative example is in a non-driving state, as shown in FIG. 10A, a plurality of circular shapes due to external light reflection can be visually recognized, or as shown in FIG. 10B, a shape in which lines of light due to external light reflection intersect can be visually recognized.

Referring to FIGS. 11A and 11B, it can be seen that when the display device 100 according to the embodiment is in a non-driving state, the mura phenomenon is significantly improved compared to the display device according to the comparative example.

In particular, it can be seen that the image level is improved as the sharpness of the external light visually recognized due to the mura phenomenon is greatly reduced.

As described above, the display devices 100, 200, and 300 according to the example embodiments of the present disclosure are designed to adjust the height of the second planarization layers 116, 216, and 316 disposed in the light-emitting areas EA that emit light of the same color among the plurality of light-emitting areas EA so that the external light incident on the light-emitting areas EA can have a phase difference of 180°, thereby reducing the external light reflectance.

By adjusting the height of the second planarization layers 116, 216, and 316 disposed in the light-emitting areas EA that emit light of the same color among the plurality of light-emitting areas EA, there is an effect of reducing design errors and maintaining the luminous efficiency of the light-emitting element. Also, thicknesses of portions of the second planarization layers 116, 216, 316 can be the same or vary depending on whether a location of the portions of the second planarization layer 116, 216, 316 is located at one of the first light-emitting area EA1, the second light-emitting area EA2, the first non light-emitting area NEA1 or the second non light-emitting area NEA2.

The heights of the planarization layers disposed in the second light-emitting area, the fourth light-emitting area, and the sixth light-emitting area can be different from each other.

The height of the planarization layer disposed in each of the second light-emitting area, the fourth light-emitting area, and the sixth light-emitting area can be lower than the height of the planarization layer disposed in each of the first light-emitting area, the third light-emitting area, and the fifth light-emitting area.

The first color is red, the second color is green, the third color is blue, the height of the planarization layer disposed in the second light-emitting area can be lower than the height of the planarization layer disposed in each of the fourth light-emitting area and the sixth light-emitting area, and the height of the planarization layer disposed in the fourth light-emitting area can be lower than the height of the planarization layer disposed in the sixth light-emitting area.

The display device can further comprise a non-light emitting area disposed in the first pixel and the second pixel, wherein in the first pixel, the planarization layer may not include a step in an area in which the non-light emitting area and the first electrode are not overlapped, and in the second pixel, the planarization layer can include at least three steps in an area in which the non-light emitting area and the first electrode are not overlapped.

Although the example embodiments of the disclosure have been described in detail with reference to the accompanying drawings, the disclosure is not limited thereto and can be embodied in various forms without departing from the technical concept of the present disclosure. Therefore, the example embodiments of the disclosure are provided for illustrative purposes only but not intended to limit the technical concept of the present disclosure. The scope of the technical concept of the disclosure is not limited thereto. Therefore, it should be understood that the above-described embodiments are illustrative in all aspects and do not limit the disclosure.

## Claims

1. A display device comprising:
a substrate (110) including a plurality of sub-pixels (SP);
a planarization layer (115, 116) disposed on the substrate (110); and
a plurality of light-emitting elements (140) disposed on the planarization layer (115, 116),
wherein the plurality of sub-pixels (SP) includes a first sub-pixel (SP1) and a second sub-pixel (SP2) spaced apart from the first sub-pixel (SP1),
wherein the first sub-pixel (SP1) includes a first light-emitting area (EA1) configured to emit light of a first color, and the second sub-pixel (SP2) includes a second light-emitting area (EA2) configured to emit light of the first color, and
wherein a height of the planarization layer (115, 116) in the first light-emitting area (EA1) is different from a height of the planarization layer in the second light-emitting area (EA2).

2. The display device according to claim 1, wherein the substrate (110) further includes a plurality of pixels (PX),
wherein at least one of the plurality of pixels (PX) includes a first sub-pixel group (SPG1), a second sub-pixel group (SPG2) spaced apart from the first sub-pixel group (SPG1), and a third sub-pixel group (SPG3) spaced apart from the second sub-pixel group (SPG2),
wherein the first sub-pixel group (SPG1) includes the first sub-pixel (SP1) and the second sub-pixel (SP2),
wherein the second sub-pixel group (SPG2) includes a third sub-pixel (SP3) and a fourth sub-pixel (SP4),
wherein the third sub-pixel group (SPG3) includes a fifth sub-pixel (SP5) and a sixth sub-pixel (SP6),
wherein the third sub-pixel (SP3) includes a third light-emitting area (EA3) configured to emit light of a second color different from the first color,
wherein the fourth sub-pixel (SP4) includes a fourth light-emitting area (EA4) configured to emit light of the second color,
wherein the fifth sub-pixel includes a fifth light-emitting area (EA5) configured to emit light of a third color different from the first color and the second color, and
wherein the sixth sub-pixel includes a sixth light-emitting area (EA6) configured to emit light of the third color.

3. The display device of claim 2, wherein a shortest distance from a center of the first light-emitting area (EA1) to a center of the second light-emitting area (EA2) is less than a shortest distance from a center of the first light-emitting area (EA1) to a center of the third light-emitting area (EA3), a shortest distance from a center of the fourth light-emitting area (EA4) from a center of the first light-emitting area (EA1), a shortest distance from a center of the first light-emitting area (EA1) to a center of the fifth light-emitting area (EA5) and a shortest distance from a center of the first light-emitting area (EA1) to a center of the sixth light-emitting area (EA6).

4. The display device of claim 2 or 3, wherein the height of the planarization layer (115, 116) in the first light-emitting (EA1) is a same as heights of the planarization layer (115, 116) in the third light-emitting area (EA3) and the fifth light-emitting area (EA5).

5. The display device according to any one of the preceding claims, wherein the first color is red and the height of the planarization layer (115, 116) in the first light-emitting area (EA1) is higher than the height of the planarization layer (115, 116) in the second light-emitting area (EA2), preferably a difference between the height of the planarization layer (115, 116) in the first light-emitting area (EA1) and the height of the planarization layer (115, 116) in the second light-emitting area (EA2) is about 1530 Å to about 1870 Å.

6. The display device according to any one of the preceding claims 2-5, wherein the second color is green and a height of the planarization layer (115, 116) in the third light-emitting area (EA3) is higher than a height of the planarization layer (115, 116) in the fourth light-emitting area (EA4), preferably a difference between the height of the planarization layer (115, 116) in the third light-emitting area (EA3) and the height of the planarization layer (115, 116) in the fourth light-emitting area (EA4) is about 1238 Å to about 1512 Å.

7. The display device according to any one of the preceding claims 2-6, wherein the third color is blue, and a height of the planarization layer (115, 116) in the fifth light-emitting area (EA5) is higher than a height of the planarization layer (115, 116) in the sixth light-emitting area, preferably a difference between the height of the planarization layer (115, 116) in the fifth light-emitting area (EA5) and the height of the planarization layer (115, 116) in the sixth light-emitting area (EA6) is about 1013 Å to about 1237 Å.

8. The display device according to any one of the preceding claims 2-7, further comprising:
a non-light emitting area (NEA) each located between the first light-emitting area (EA1) and the second light-emitting area (EA2), between the third light-emitting area (EA3) and the fourth light-emitting area (EA4), and between the fifth light-emitting area (EA5) and the sixth light-emitting area (EA6), wherein the planarization layer (115) includes:
at least one first step (116a) disposed in the non-light emitting area (NEA) between the first light-emitting area (EA1) and the second light-emitting area (EA2),
at least one second step (116b) disposed in the non-light emitting area (NEA) between the third light-emitting area (EA3) and the fourth light-emitting area (EA4), and
at least one third step (116c) disposed in the non-light emitting area (NEA) between the fifth light-emitting area (EA5) and the sixth light-emitting area (EA6), preferably a height of the first step (116a), a height of the second step (116b), and a height of the third step (116c) are different from each other.

9. The display device of any one of the preceding claims, wherein the plurality of light-emitting elements (140) further includes a first light-emitting element (140a) disposed in the first light-emitting area (EA1) and a second light-emitting element (140b) disposed in the second light-emitting area (EA2),
wherein the first light-emitting element (140a) includes a first organic layer (142a),
wherein the second light-emitting element (140b) includes a second organic layer (142b), and
wherein a thickness of the first organic layer (142a) and a thickness of the second organic layer (142b) are a same.

10. The display device according to any one of the preceding claims, wherein the planarization layer (115, 116) further includes a first planarization layer (115) and a second planarization layer (116) disposed on the first planarization layer (115),
wherein the plurality of light-emitting elements (140) further includes a first light-emitting element (140a) which is disposed on the second planarization layer (116) in the first light-emitting area (EA1) and includes a first anode electrode (141a), and a second light-emitting element (140b) which is disposed on the second planarization layer (116) in the second light-emitting area (EA2) and includes a second anode electrode (141b),
wherein a first connection electrode (219) is disposed on the first planarization layer (115) and disposed in the first sub-pixel (SP1), and a second connection electrode (220) is spaced apart from the first connection electrode (219) and disposed in the second sub-pixel (SP2),
wherein a part of the first connection electrode (219) in the first light-emitting area (EA1) overlaps the first anode electrode (141a), and the second connection electrode (220) in the second light-emitting area (EA2) overlaps the second anode electrode (141b), preferably a plurality of connection electrode patterns (220a) is disposed on a same layer as the second connection electrode (220) in the second light-emitting area (EA2).

11. The display device according to any one of the preceding claims 2-10, wherein the substrate further includes a first pixel (PX1) and a second pixel (PX2) disposed to be adjacent to the first pixel (PX1) in one direction,
wherein the first pixel (PX1) includes the first light-emitting area (EA1), a third light-emitting area (EA3) spaced apart from the first light-emitting area (EA1), and a fifth light-emitting area (EA5),
wherein the second pixel (PX2) includes the second light-emitting area (EA2), a fourth light-emitting area (EA4) spaced apart from the second light-emitting area (EA2), and a sixth light-emitting area (EA6),
wherein each of the third light-emitting area (EA3) and the fourth light-emitting area (EA4) is configured to emit light of a second color different from the first color,
wherein each of the fifth light-emitting area (EA1) and the sixth light-emitting area (EA6) is configured to emit light of a third color different from the first color and the second color, and
preferably a center distance from a center of the first light-emitting area (EA1) to a center of the third light-emitting area (EA3) is shorter than a center distance from the center of the first light-emitting area (EA1) to a center of the fourth light-emitting area (EA4).

12. The display device of any one of the preceding claims 2-11, wherein the height of the planarization layer (115, 116) disposed in the first light-emitting area (EA1) is a same as heights of the planarization layer (115, 116) disposed in the third light-emitting area (EA3) and the fifth light-emitting area (EA5).

13. The display device according to any one of the preceding claims 2-12, wherein heights of the planarization layer (115, 116) disposed in the second light-emitting area (EA2), the fourth light-emitting area (EA4), and the sixth light-emitting area (EA6) are different from each other, and/or the heights of the planarization layer (115, 116) disposed in each of the second light-emitting area (EA2), the fourth light-emitting area (EA4), and the sixth light-emitting area (EA6) are lower than the height of the planarization layer (115, 116) disposed in each of the first light-emitting area (EA1), the third light-emitting area (EA3), and the fifth light-emitting area (EA5).

14. The display device of any one of the preceding claims 2-13, wherein the first color is red, the second color is green, and the third color is blue,
wherein the height of the planarization layer (115, 116) disposed in the second light-emitting area (EA2) is lower than the height of the planarization layer (115, 116) disposed in each of the fourth light-emitting area (EA4) and the sixth light-emitting area (EA6), and
the height of the planarization layer (115, 116) disposed in the fourth light-emitting area (EA4) is lower than the height of the planarization layer (115, 116) disposed in the sixth emission area (EA6).

15. The display device of claim 14, further comprising:
a non-light emitting area (NEA) disposed in the first pixel (PX1) and the second pixel (PX2),
wherein in the first pixel (PX1), the planarization layer (115, 116) does not include a step in an area in which the non-light emitting area (NEA) and the first electrode (141a) do not overlap, and
wherein in the second pixel (PX2), the planarization layer (115, 116) includes at least three steps in an area in which the non-light emitting area (NEA) and the first electrode (141b) do not overlap.
